# EUROPÄISCHE PATENTSCHRIFT

(11) **EP 3 180 800 B1**
(45) Veröffentlichungstag und Bekanntmachung des Hinweises auf die Patenterteilung: **22.12.2021**
(21) Anmeldenummer: 15738293.8
(22) Anmeldetag: 06.07.2015
(51) Int. Cl.: H01L 21/67, H01L 21/3065, H01J 37/32

(54) **VORRICHTUNG ZUM ANISOTROPEN ÄTZEN EINES SUBSTRATS UND VERFAHREN ZUM BETREIBEN EINER VORRICHTUNG ZUM ANISOTROPEN ÄTZEN EINES SUBSTRATS**
DEVICE FOR ANISOTROPICALLY ETCHING A SUBSTRATE, AND METHOD FOR OPERATING A DEVICE FOR ANISOTROPICALLY ETCHING A SUBSTRATE
DISPOSITIF DE GRAVURE ANISOTROPE D'UN SUBSTRAT ET PROCÉDÉ POUR FAIRE FONCTIONNER UN DISPOSITIF DE GRAVURE ANISOTROPE D'UN SUBSTRAT

(30) Priorität: 14.08.2014 DE 102014216195
(43) Veröffentlichungstag der Anmeldung: 21.06.2017
(73) Patentinhaber: Robert Bosch GmbH, 70442 Stuttgart (DE)
(72) Erfinder: LAERMER, Franz, 71263 Weil der Stadt (DE)
(86) Internationale Anmeldenummer: PCT/EP2015/065298
(87) Internationale Veröffentlichungsnummer: WO 2016/023683

(56) Entgegenhaltungen:
- WO-A1-03/060975
- JP-A- 2000 091 320
- US-A1- 2004 134 615
- US-A1- 2009 244 471
- US-B1- 6 287 643

## Beschreibung

Die vorliegende Erfindung betrifft eine Vorrichtung zum anisotropen Ätzen eines Substrats, insbesondere eines Siliziumsubstrats, bevorzugt eines 8-Zoll oder 200-mm-Siliziumwafers, sowie ein Verfahren zum Betreiben der erfindungsgemäßen Vorrichtung.

Fluorbasierte Hochratenätzprozesse für Silizium, sogenannte DRIE-Prozesse, benötigen sowohl siliziumätzende Fluorradikale als auch Teflon-bildende Spezies, so genannte Passivierspezies, welche Seitenwände von Siliziumstrukturen passivieren und vor einem Ätzangriff oder einem Unterätzen durch die spontan agierenden, hochreaktiven Fluorradikale schützen. Die Fluorradikale und die Teflon-bildenden Spezies werden in einem Plasma erzeugt. Dort koexistieren sie jedoch im Allgemeinen nicht, sondern löschen sich in dem Plasma durch Rekombinationsreaktionen gegenseitig aus.

In der US 5 501 893 ist ein Verfahren beschrieben, gemäß welchem Ätz- und Passivierschritte bei dem Ätzen eines Substrats zeitlich voneinander getrennt werden. Durch die zeitliche Trennung wird ein Kontakt der beiden Spezies vermieden, so dass voneinander unabhängig geätzt und passiviert werden kann.

In der US 2004/134615 A1 sind eine Vorrichtung und ein Verfahren zum anisotropen Plasmaätzen eines Substrats beschrieben.

In der US 2009/244471 A1 sind ein Flüssigkristallbildschirm und ein Verfahren zum Herstellen eines Flüssigkristallbilschirms beschrieben.

In der US 6 287 643 B1 sind eine Vorrichtung und ein Verfahren zum Injizieren und Modifizieren einer Gaskonzentration in einem Plasmareaktor beschrieben.

In der JP 2000 091320 A ist eine Plasmabehandlungsvorrichtung beschrieben.

In der WO 03/060975 A1 sind ein Verfahren und eine Vorrichtung zum anisotropen Ätzen beschrieben.

### Offenbarung der Erfindung

Die vorliegende Erfindung offenbart eine Vorrichtung mit den Merkmalen des Patentanspruchs 1 und ein Verfahren mit den Merkmalen des Patentanspruchs 9.

### Vorteile der Erfindung

Die der vorliegenden Erfindung zugrunde liegende Erkenntnis besteht darin, dass eine unerwünschte Rekombination von Silizium-ätzenden Fluorradikalen und passivierenden, d.h. Teflon-bildenden Spezies überwunden werden kann, wenn sich diese nicht bereits in einem Reaktionsbereich eines hochdichten Plasmas einer Plasmaquelle, das heißt am Ort des Entstehens der jeweiligen Spezies, sondern erst außerhalb der Plasmaerzeugungs- bzw. Plasmareaktionszonen vermischen. Werden die Erzeugung von Teflon-bildenden Spezies aus einem Passiviergas und die Erzeugung der Silizium-ätzenden Fluorradikale aus einem Ätzgas räumlich voneinander getrennt, kann bereits mit einem vergleichsweise geringen Anteil an dem Passiviergas gegenüber dem Ätzgas ein anisotropes Ätzergebnis mit sehr hohen Ätzraten und Maskenselektivität ohne Nachteile gegenüber einem diskontinuierlichen Verfahren erreicht werden. Die - an sich erstaunliche - Unbedenklichkeit eines Vermischens der Plasmaprodukte, also der Teflon-bildenden Passivierspezies und der Silizium-ätzenden Fluorradikale als Ätzspezies außerhalb der jeweiligen Entstehungszonen beruht auf einer hinreichend großen Kettenlänge der Plasma-polymerisierten Teflon-bildenden Spezies, und erlaubt im Grundsatz einen kontinuierlich arbeitenden Fluorbasierten Hochratenätzprozess für Silizium, bei welchem die zeitliche Trennung der Spezies durch eine räumliche Trennung im Bereich der Reaktionsbereiche bzw. Entstehungszonen der Spezies ersetzt wird.

Die der vorliegenden Erfindung zugrunde liegende Idee besteht nun darin, dieser Erkenntnis Rechnung zu tragen und eine Vorrichtung bereitzustellen, welche separate Reaktionskammern als Reaktionsbereich für das Erzeugen der Teflon-bildenden Spezies aus dem Passiviergas einerseits und das Erzeugen der Silizium-ätzenden Fluorradikale aus dem Ätzgas andererseits aufweist. Zum geeigneten anisotropen Ätzen des Substrats weist die Vorrichtung die beschriebene Vermengungseinrichtung auf, mittels welcher die separat erzeugten reaktiven Spezies vorteilhaft miteinander vermengt werden können, bevor sie zum anisotropen Ätzen auf das Substrat auftreffen. Eine Vermengung beider Spezies ist vorteilhaft, um ein möglichst gleichmäßiges, d.h. homogenes Ätzergebnis über die ganze Fläche des zu prozessierenden Siliziumwafers zu erzielen.

Ungeladene reaktive Spezies folgen auf ihrem Weg von ihrem jeweiligen Reaktionsbereich, also Erzeugungsbereich, in die Ätzkammer zum Wirken auf das Substrat, das heißt zum Anisotropen Ätzen des Substrats, den jeweiligen Gasströmungen, insbesondere Gasströmungen, welche auf Stärken basieren, mit welchen das erste und das zweite Gas in die erste und die zweite Reaktionskammer eingeleitet werden.

Die Teflon-bildenden reaktiven Spezies sind dazu geeignet, auf einer Oberfläche des zu ätzenden Substrats, insbesondere auf Seitenwänden von in dem Substrat mittels der Fluorradikale geätzten Strukturen, einen Teflon-artigen Schutzfilm aufzubauen, welcher die Seitenwände vor einem Angriff durch die Fluorradikale schützt. Der Teflon-artige Schutzfilm wird auch kurz Teflonfilm, Seitenfilm oder Seitenwandfilm genannt. Die im Passivierplasma erzeugten Teflon-bildenden reaktiven Spezies weisen vorteilhafterweise eine Mindestgröße oder Mindestlänge, auch Mindestkettenlänge genannt, auf, um auf dem Substrat kondensieren und dort zu dem Teflonfilm vernetzen zu können. Bevorzugt sind zehn bis hundert Kohlenstoffatome pro Molekül der Teflon-bildenden reaktiven Spezies. Die Moleküle der Teflon-bildenden reaktiven Spezies können beispielsweise die Form (CFₙ)ₘ aufweisen, wobei m größer neun und kleiner einhunderteins und n zwischen null und drei sein kann, wobei der Fall von n gleich zwei bevorzugt bzw. die übliche Stöchiometrie einer Teflonkette ist.

Vorteilhafte Ausführungsformen und Weiterbildungen ergeben sich aus den Unteransprüchen sowie aus der Beschreibung unter Bezugnahme auf die Figuren.

Gemäß einer ersten bevorzugten Weiterbildung weist die Vermengungseinrichtung eine sich in Richtung der Ätzkammer trichterförmig verjüngende, insbesondere hohlkegelstumpfförmige, Führungseinrichtung zum Vermengen und/oder Führen der miteinander vermengten mindestens einen ersten reaktiven Spezies und mindestens einen zweiten reaktiven Spezies auf das Substrat auf. Hierdurch sind die beiden reaktiven Spezies besser miteinander vermengbar und gezielt auf das Substrat führbar.

Erfindungsgemäß weist die Vermengungseinrichtung mindestens eine erste Umleitungseinrichtung auf, mittels welcher, zum Umleiten mindestens eines Teils der erzeugten mindestens einen ersten reaktiven Spezies, ein direkter Weg der erzeugten mindestens einen ersten reaktiven Spezies aus der ersten Reaktionskammer zu dem Substrat teilweise oder vollständig versperrt ist. Gasflüsse der reaktiven Spezies sind hierdurch so formbar, dass eine besonders homogene Vermengung der unterschiedlichen Spezies außerhalb, insbesondere unterhalb der Erzeugungszonen der jeweiligen Reaktionskammern stattfindet. Erfindungsgemäß ist die erste Umleitungseinrichtung derart angeordnet, dass Gasströme der ersten reaktiven Spezies und der zweiten reaktiven Spezies ineinander gerichtet werden, wodurch sich über eine kürzere Wegstrecke eine wesentlich schnellere und vollständigere Durchmischung ergibt. Die Umleitungseinrichtung ist bevorzugt aus einem dielektrischen Material, beispielsweise Quartzglas, gefertigt.

Gemäß einer weiteren bevorzugten Weiterbildung ist die Vermengungseinrichtung als eine Diffusionsstrecke ausgebildet. Unter einer Diffusionsstrecke ist ein Laufweg der Gase bzw. reaktiven Spezies zwischen den Reaktionskammern bzw. Erzeugungsbereichen einerseits, und der eigentlichen Ätzkammer andererseits, zu verstehen. D.h. eine Wegstrecke, die die gasförmigen reaktiven Spezies nach ihrer Erzeugung bis zu dem Substrat in der Ätzkammer überwinden müssen und über die sie sich vorteilhaft durch Inter-Diffusionsvorgänge miteinander durchmischen können.

Gemäß einer weiteren bevorzugten Weiterbildung ist zumindest ein erster Teilbereich der ersten Reaktionskammer vollständig von zumindest einem zweiten Teilbereich der zweiten Reaktionskammer umschlossen. Vorteilhaft kann die erste Reaktionskammer auch vollständig von dem zweiten Teilbereich der zweiten Reaktionskammer umschlossen sein. Besonders vorteilhaft sind die erste und die zweite Reaktionskammer als rotationssymmetrische dielektrische Kessel, insbesondere mit jeweils einer Form eines Hohlzylinders, ausgeführt, welche konzentrisch ineinander geschachtelt sind. Vorteilhaft befindet sich die erste Reaktionskammer näher an der gemeinsamen virtuellen Achse als die zweite Reaktionskammer und/oder umfasst ein geringeres Volumen als die zweite Reaktionskammer. In axialer Richtung der virtuellen Achse können die erste und die zweite Reaktionskammer beispielsweise miteinander an beiden axialen Enden bündig abschließen oder an einem axialen Ende bündig abschließen und sich an einem anderen, entgegengesetzten Ende in axialer Richtung unterschiedlich weit erstrecken. Dadurch kann die Vorrichtung besonders platzsparend ausgebildet sein und es können Bestandteile der Vorrichtung, wie beispielsweise die die elektromagnetischen Wechselfelder erzeugenden Spuleneinrichtungen, für die erste und die zweite Reaktionskammer gemeinsam nutzbar sein.

Gemäß einer weiteren bevorzugten Weiterbildung weist die Spuleneinrichtung eine erste induktive Spule auf, welche zum Beaufschlagen der ersten Reaktionskammer mit einem ersten elektromagnetischen Wechselfeld ausgebildet ist; und weiterhin eine zweite induktive Spule auf, welche zum Beaufschlagen der zweiten Reaktionskammer mit einem zweiten elektromagnetischen Wechselfeld ausgebildet ist. Das Beaufschlagen der beiden Reaktionskammern mit dem elektromagnetischen Wechselfeld ist auch als Einkoppeln einer ersten Hochfrequenz in die erste Reaktionskammer und einer zweiten Hochfrequenz in die zweite Reaktionskammer bezeichenbar. Die induktiven Spulen können zum Erzeugen einander gleichender elektromagnetischer Feld, oder voneinander verschiedener elektromagnetischer Felder ausgebildet sein, beispielsweise in Bezug auf Intensität, Flussdichte etc. Durch ein separates Erzeugen der beiden elektromagnetischen Wechselfelder kann eine Intensität einer in die jeweilige Reaktionskammer eingekoppelten Hochfrequenzleistung separat steuerbar und somit für das jeweilige Erzeugen der reaktiven Spezies individuell anpassbar bzw. optimierbar sein.

Gemäß einer weiteren bevorzugten Weiterbildung weist die erste Reaktionskammer eine erste Einleitung zum Einleiten des ersten Gases in die erste Reaktionskammer auf, wobei die erste Einleitung über eine erste Ventileinrichtung mit einem ersten Gastank sowie mit einem zweiten Gastank verbunden ist, wobei die erste Ventileinrichtung steuerbar ist, entweder eine in dem ersten Gastank bereitgestellte erste Gasspezies oder eine in dem zweiten Gastank bereitgestellte zweite Gasspezies als das erste Gas in die erste Reaktionskammer einzuleiten. Gemäß einer weiteren bevorzugten Weiterbildung weist die zweite Reaktionskammer eine zweite Einleitung zum Einleiten des zweiten Gases in die zweite Reaktionskammer auf, wobei die zweite Einleitung über eine zweite Ventileinrichtung mit dem ersten Gastank sowie mit dem zweiten Gastank verbunden ist, wobei die zweite Ventileinrichtung steuerbar ist, entweder die in dem ersten Gastank bereitgestellte erste Gasspezies oder die in dem zweiten Gastank bereitgestellte zweite Gasspezies als das zweite Gas in die zweite Reaktionskammer einzuleiten.

Hierdurch ist es möglich, in die erste Reaktionskammer entweder ein Passiviergas oder ein Ätzgas einzuleiten und/oder in die zweite Reaktionskammer entweder ein Ätzgas oder ein Passiviergas einzuleiten, insbesondere automatisch und ohne dazu einen manuellen Umbau vornehmen zu müssen. Beide Varianten zur Zufuhr der beiden Gase können trotz einer nachfolgenden Durchmischung der beiden erzeugten reaktiven Spezies bis zum Ort des zu ätzenden Substrats zu spezifischen Inhomogenitäten bezüglich der resultierenden Spezieszusammensetzung führen, welche vorteilhaft oder nachteilhaft sein kann. Durch das Umschalten zwischen den beiden Zufuhrvarianten während eines Ätzprozesses kann diese Inhomogenität durch einen "Mittelungseffekt" reduziert werden. Alternativ kann man eine Zufuhrvariante gezielt so wählen, dass durch die dadurch bewirkte Inhomogenität andere Prozess-bedingte Inhomogenitäten korrigiert werden. Beispielsweise kann es bei einem Siliziumätzprozess von Vorteil sein, wenn das Passiviergas, auf eine Flächennormale einer zu ätzenden Oberfläche des zu ätzenden Wafers bezogen in radialer Richtung, weiter außen als das Ätzgas erzeugt wird. Dies hat im Allgemeinen einen etwas höheren Anteil von passivierenden, das heißt Teflon-bildenden, Spezies in, wiederum in radialer Richtung, Randbereichen der Ätzkammer sowie des zu ätzenden Substrats zur Folge. Beispielsweise tendieren Fluor-basierte Siliziumätzprozesse häufig zu einem Ätzratenanstieg über den Siliziumwafer als Substrat von der Wafermitte zum Waferrand, da außerhalb des Siliziumwafers, also jenseits seines Randes, kein Fluorradikale verzehrendes Silizium mehr zur Verfügung steht.

Infolgedessen steht in den Randbereichen des Siliziumwafers eine höhere Konzentration von Silizium-ätzenden Fluorradikalen zur Verfügung als in der Wafermitte, welche vollständig von zu ätzendem Silizium umgeben ist. Eine gezielte Erhöhung der Dichte der filmbildenden reaktiven Spezies im Randbereich des Siliziumwafers gegenüber der Wafermitte kann einen solchen Effekt zumindest teilweise kompensieren und für eine bessere Uniformität der Ätzergebnisse sorgen. Bei dieser Einstellung wird somit ein Prozess-bedingter Ätzratenanstieg von Wafermitte zum Waferrand reduziert werden.

Beabsichtigt man hingegen einen Wechsel der Gaszufuhrvariante während eines Prozesses oder zwischen verschiedenen Prozessen, so kann hierzu eine Betätigung der ersten und/oder zweiten Ventileinrichtungen beispielsweise pneumatisch oder elektromagnetisch erfolgen. Die erste und die zweite Ventileinrichtung können als zwei gekoppelte Drei-Wege-Ventile ausgebildet sein, welche jeweils als Y-Ventil das betreffende erste oder zweite Gas wahlweise in die erste oder die zweite Reaktionskammer schalten. Das Schalten der ersten und zweiten Ventileinrichtungen kann mittels einer Steuereinrichtung der erfindungsgemäßen Vorrichtung erfolgen.

Gemäß einer weiteren bevorzugten Weiterbildung weist die Vorrichtung eine Temperierungseinrichtung auf, mittels welcher das Substrat auf eine vorgegebene Betriebstemperatur bringbar und auf der vorgegebenen Betriebstemperatur haltbar ist. Die Temperierungseinrichtung ist vorteilhafterweise zum Bringen und Halten des Substrats auf die vorgegebene Betriebstemperatur zwischen 20°C und 90°C ausgebildet, vorteilhaft zwischen 30°C und 80°C, besonders vorteilhaft zwischen 40°C und 70°C, jeweils einschließlich. Die Temperierungseinrichtung kann dazu einen sogenannten "Heater-Chiller" mit deionisiertem Wasser, Silikonölen oder Fluorkarbonen als Wärmetransportmedium zur Substratelektrode und/oder eine Helium-Wafer-Rückseitenkühlung als Wärmekontaktmedium zwischen Wafer, d.h. Substrat, und Substratelektrode umfassen. Mittels der Betriebstemperatur des Wafers ist eine Kondensationsschwelle vorgebbar, welche eine Mindestkettenlänge der Passivierspezies beschreibt, welche zum Kondensieren der Passivierspezies auf dem Substrat überschritten werden muss. Zusammen mit einem bevorzugten Erzeugen besonders langkettiger Passivierspezies kann somit das bevorzugte Ausbilden einer besonders weichen und lose vernetzten Filmmorphologie des Teflonfilms auf dem Substrat erreicht werden, indem z.B. bei höherer Wafertemperatur nur relativ langkettige Teflonfilm-bildende Spezies auf dem Wafer kondensieren und dort vernetzen können.

Gemäß einer bevorzugten Weiterbildung des erfindungsgemäßen Verfahrens wird als das erste Gas ein Passiviergas oder ein Ätzgas eingeleitet und als das zweite Gas ein Ätzgas eingeleitet, wenn als das erste Gas ein Passiviergas eingeleitet wird, sowie als das zweite Gas ein Passiviergas eingeleitet, wenn als das erste Gas ein Ätzgas eingeleitet wird. Das Passiviergas ist vorteilhafterweise ein Fluorkohlenwasserstoff, ein perfluoriertes Alken, insbesondere Perfluorpropen oder ein perfluoriertes Alkin. Besonders bevorzugt ist ein zyklisches perfluoriertes Alkan, insbesondere Octafluorcyclobutan. Als Passivierspezies kommen weiterhin vor allem aus Passiviergasen oder anderen Fluorkohlen(wasser)stoffen erzeugte Teflon-bildende Monomere mit vorzugsweise niedrigem Fluor-zu-Kohlenstoff-Verhältnis, insbesondere zwei zu eins oder niedriger, in Frage. Das Ätzgas ist vorteilhafterweise Schwefelhexafluorid, Stickstofftrifluorid, Chlortrifluorid und/oder Bromtrifluorid, besonders bevorzugt Schwefelhexafluorid.

Gemäß einer weiteren bevorzugten Weiterbildung umfasst das Verfahren, dass mindestens einmal mit einer vorbestimmten Umschaltfrequenz zwischen einem ersten Betriebsmodus und einem zweiten Betriebsmodus umgeschaltet wird, wobei in dem ersten Betriebsmodus als das erste Gas ein Ätzgas und als das zweite Gas ein Passiviergas eingeleitet wird, und wobei im zweiten Betriebsmodus als das erste Gas ein Passiviergas und als das zweite Gas ein Ätzgas eingeleitet wird. Die Umschaltfrequenz kann insbesondere zwischen 10 Hertz und 3 Millihertz liegen. Besonders vorteilhaft wird eine Umschaltfrequenz zwischen 1 Hertz und 30 Millihertz gewählt, besonders bevorzugt eine Umschaltfrequenz zwischen 100 Millihertz und 50 Millihertz. Die eingestellten Gasflüsse des Ätzgases und des Passiviergases brauchen dabei nicht variiert zu werden, da beispielsweise mittels der oben beschriebenen beiden Ventileinrichtungen, insbesondere Drei-Wege- bzw. Y-Ventile, zwischen einem Zuleiten an die erste Reaktionskammer und einem Zuleiten an die zweite Reaktionskammer umgeschaltet werden kann. Alternativ ist es auch möglich, synchron zu den Umschaltvorgängen die Gasflüsse des ersten und des zweiten Gases, das heißt des Ätz- und des Passiviergases, zu verändern. Beispielsweise können die Gasflüsse des ersten und des zweiten Gases unterschiedlichen räumlichen Volumenverhältnissen der ersten und der zweiten Reaktionskammer angepasst werden, um möglichst stabile Plasmabedingungen in den jeweiligen Reaktionskammern zu erhalten und aufrechtzuerhalten. Die Option des Umschaltens der Prozessgase zwischen den Reaktionskammern während eines Prozesses oder zwischen verschiedenen Prozessen ermöglicht es, eine schädliche Akkumulation von Teflonfilm-Material in den Reaktionskammern selbst zu vermeiden, indem eine entstehende Kammerbeschichtung regelmäßig wieder rückgeätzt wird. Dadurch wird einer Freisetzung von unerwünschten Partikeln vorgebeugt.

Auch die Wechselfelder, welche an die jeweiligen Reaktionskammern angelegt werden, können vorteilhaft an das eingeleitete Gas angepasst werden. Beispielsweise kann, zum Erzeugen möglichst langkettiger Plasmapolymere aus dem Passiviergas, das Wechselfeld, mit welchem das Passiviergas beaufschlagt wird, eine höhere Leistung aufweisen als das Wechselfeld, mit welchem das Ätzgas beaufschlagt wird, insbesondere eine zwischen dreißig und zweihundert Prozent höhere Leistung, bevorzugt eine zwischen vierzig und hundert Prozent höhere Leistung, besonders bevorzugt eine zwischen fünfundvierzig und siebzig Prozent höhere Leistung.

Das abwechselnde Umschalten des Ätz- und des Passiviergases zwischen der ersten und der zweiten Reaktionskammer führt zu einer im Zeitmittel verbesserten Homogenität des Gemenges aus den miteinander vermengten Ätz-und Passivierspezies nach dem Durchqueren der Vermengungseinrichtung bis zum Ort des Substrats. Durch ein regelmäßiges oder gezieltes Umschalten von dem ersten Betriebsmodus in den zweiten Betriebsmodus oder umgekehrt kann eine Partikelbildung an Innenwänden der ersten und zweiten Reaktionskammer vermieden werden.

### Kurze Beschreibung der Zeichnungen

Die vorliegende Erfindung wird nachfolgend anhand der in den schematischen Figuren der Zeichnungen dargestellten Ausführungsbeispiele näher erläutert. Es zeigen:
- Fig. 1: eine schematische Querschnittsansicht durch eine Vorrichtung zum anisotropen Ätzen eines Substrats gemäß einer ersten Ausführungsform der vorliegenden Erfindung;
- Fig. 2: eine schematische Querschnittsansicht durch eine Vorrichtung zum anisotropen Ätzen eines Substrats gemäß einer zweiten Ausführungsform der vorliegenden Erfindung;
- Fig. 3: eine schematische Querschnittsansicht durch eine Vorrichtung zum anisotropen Ätzen eines Substrats gemäß einer dritten Ausführungsform der vorliegenden Erfindung;
- Fig. 4: eine schematische Querschnittsansicht durch eine Vorrichtung zum anisotropen Ätzen eines Substrats gemäß einer vierten Ausführungsform der vorliegenden Erfindung;
- Fig. 5: eine schematische Querschnittsansicht durch eine Vorrichtung zum anisotropen Ätzen eines Substrats gemäß einer fünften Ausführungsform der vorliegenden Erfindung;
- Fig. 6: eine schematische Querschnittsansicht durch eine Vorrichtung zum anisotropen Ätzen eines Substrats gemäß einer sechsten Ausführungsform der vorliegenden Erfindung;
- Fig. 7a: bis Fig. 7f2 verschiedene Gestaltungsformen zum Speisen einer oder mehrerer induktiver Spulen einer erfindungsgemäßen Vorrichtung;
- Fig. 8: eine schematische Querschnittsansicht durch eine Vorrichtung zum anisotropen Ätzen eines Substrats gemäß einer siebten Ausführungsform der vorliegenden Erfindung;

In allen Figuren sind gleiche bzw. funktionsgleiche Elemente und Vorrichtungen - sofern nichts anderes angegeben ist - mit denselben Bezugszeichen versehen.

### Beschreibung der Ausführungsbeispiele

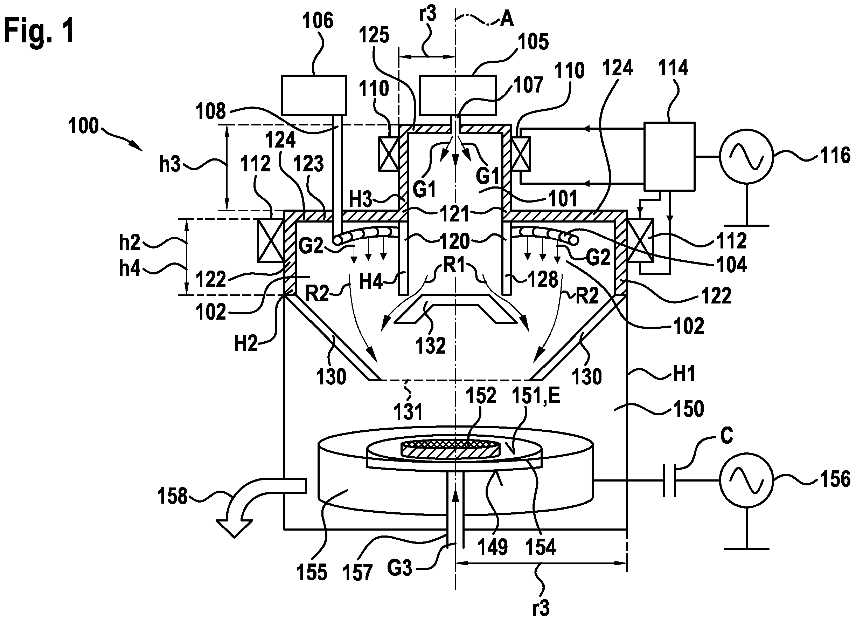

Fig. 1 zeigt eine schematische Querschnittsansicht durch eine Vorrichtung 100 zum anisotropen Ätzen eines Substrats 152 gemäß einer ersten Ausführungsform der vorliegenden Erfindung. Das zu ätzende Substrat 152, im vorliegenden Beispiel ein Siliziumsubstrat, ist auf eine erste Außenfläche 151 einer elektrostatischen Einspannvorrichtung 154 eines Träger 155 auflegbar. Der Träger 155 ist über ein Anpassnetzwerk, schematisch als ein Kondensator C vereinfacht dargestellt, mit einem ersten Hochfrequenz-Wechselspannungsgenerator 156 verbunden, mittels welchem der Träger 155 mit einer ersten Hochfrequenz-Wechselspannung beaufschlagbar ist. Über eine Kühlzuleitung 157, welche Teil einer umfassenderen Temperierungseinrichtung sein kann ist Heliumgas, als Wärmekontaktmedium zur thermischen Ankopplung des Substrats 152, an eine zweite Außenfläche 149 des Trägerabschnitts 154 leitbar. Die zweite Außenfläche 149 der Einspannvorrichtung 154 ist parallel zu der ersten Außenfläche 151 der Einspannvorrichtung 154. Der Träger 155 wird mittels eines Flüssigkühlkreislaufs auf der gewünschten voreingestellten Temperatur gehalten und ist in einer Ätzkammer 150 angeordnet, aus welcher Gas mittels einer Pumpeinrichtung 158 auspumpbar ist.

Die erste Außenfläche 151 der Einspanneinrichtung 154 liegt vollständig in einer virtuellen Ebene E, deren Flächennormale parallel zu einer virtuellen Achse A ist, welche eine Rotationssymmetrieachse des Trägers 155 ist. Im Wesentlichen, das heißt bis auf einige unwesentliche Ausnahmen, welche beispielsweise durch die Pumpeinrichtung 158 oder elektrische Verbindungen zwischen dem Träger 155 und dem ersten Hochfrequenz-Wechselstromgenerator sowie den entsprechenden elektrischen Leitungen gegeben sind, ist auch die Ätzkammer 150 rotationssymmetrisch um die virtuelle Achse A des Trägers 155. Wo im Folgenden von "innen" und "außen" die Rede ist, soll, sofern nicht explizit etwas anderes beschrieben ist, unter "innen" stets eine, in radialer Richtung bezogen auf die virtuelle Achse A, näher an der virtuellen Achse A gelegene Position und unter "außen" stets eine, in radialer Richtung bezogen auf die virtuelle Achse A, entfernter von der virtuellen Achse A gelegene Position verstanden werden. Beispielsweise ist unter einer Innenfläche eine der virtuellen Achse zugewandte Fläche und unter einer Außenfläche eine der virtuellen Achse abgewandte Fläche zu verstehen.

Die Ätzkammer 150 hat im Wesentlichen die Form eines, in axialer Richtung, einseitig geschlossenen ersten Hohlzylinders H1. An das offene Ende des ersten Hohlzylinders H1 schließt sich ein zweiter, in axialer Richtung mittels einer Deckelfläche 123 einseitig geschlossener zweiter Hohlzylinder H2 mit einer Mantelfläche 122 an. Unter einer Mantelfläche soll auch eine Wand mit endlicher Dicke verstanden werden.

Die Mantelfläche 122 des zweiten Hohlzylinders H2 kann beispielsweise Aluminiumoxid-Keramik oder Quartzglas aufweisen oder daraus bestehen. Im Fall von Keramik kann ein "Grünling" in der benötigten Geometrie gegossen bzw. geformt und anschließend gebrannt/gesintert ("fired") werden.

Die axiale Deckelfläche 123 des zweiten und, indirekt, auch des ersten Hohlzylinders H2, H1 ist nicht vollständig plan, sondern umfasst eine plane Kreisringscheibe 124, aus welcher ein, in axialer Richtung, einseitig geschlossener, dritter Hohlzylinder H3 mit einer Mantelfläche 121, mit einem Radius r3 und einer Zylinderhöhe h3, als Teil der Deckelfläche 123 extrudiert ist. Der dritte Hohlzylinder H3 ist rotationssymmetrisch um die virtuelle Achse A und konzentrisch mit der ebenfalls um die virtuelle Achse A rotationssymmetrischen Kreisringscheibe 124 angeordnet. Der dritte Hohlzylinder H3 ist in Richtung der Ätzkammer 150 offen.

Wo die Außenwände 121 des dritten Hohlzylinders an die Kreisringscheibe 124 der Deckelfläche 123 angrenzen, ist eine Trenneinrichtung 120 in den zweiten Hohlzylinder H2 eingesetzt. Die Trenneinrichtung 120 ist als, in axialer Richtung, beidseitig offener vierter Hohlzylinder H4 mit dem gleichen oder einem ähnlich großen Zylinderradius r3 wie der dritte Hohlzylinder H3 ausgebildet. Der Zylinderradius r3 des dritten Hohlzylinders H3 ist kleiner als der Zylinderradius r1 des zweiten Hohlzylinders H2, welcher gleich dem Zylinderradius r1 des ersten Hohlzylinders H1 sein kann. Der vierte Hohlzylinder H4 weist eine Mantelfläche 128 sowie eine Zylinderhöhe h1 auf, welche gleich einer Zylinderhöhe h2 des zweiten Hohlzylinders H2 sein kann.

Der Innenraum des dritten und des vierten Hohlzylinders H3, H4 zusammen bilden eine erste Reaktionskammer 101. Die erste Reaktionskammer 101 umfasst somit ein zylinderförmiges Volumen mit dem Radius r3 und einer Zylinderhöhe, welche die Summe aus der Zylinderhöhe h3 des dritten Hohlzylinders H3 und der Zylinderhöhe h4 des vierten Hohlzylinders H4 ist. Ein Volumen zwischen der Innenfläche der Mantelfläche 122 des zweiten Hohlzylinders H2 und der Außenfläche der Mantelfläche 128 des vierten Hohlzylinders H4 bildet eine zweite Reaktionskammer 102. Unter Vernachlässigung von Wanddicken ist das Volumen der zweiten Reaktionskammer 102 das Produkt aus der Zylinderhöhe h2, der Kreiszahl Pi und der Differenz der Quadrate der Zylinderradien r1 und r3.

Mittels der Trenneinrichtung 120 ist ein direkter Gasaustausch, das heißt insbesondere ein Gasaustausch auf direktem Weg, zwischen der ersten Reaktionskammer 101 und der zweiten Reaktionskammer 102 im Bereich der Plasmaerzeugungszone baulich unterbunden. Unter einem direkten Weg soll insbesondere ein Weg entlang einer gerade Linie verstanden werden. Ein zu vernachlässigender Leck-Gasaustausch, welcher auf einer nicht vollständigen Dichtigkeit zwischen der ersten Reaktionskammer 101 und der zweiten Reaktionskammer 102 am Übergang zwischen der Trenneinrichtung 120 und dem dritten Hohlzylinder 103 beruht, kann toleriert werden.

Die Trenneinrichtung 120 kann aus Keramikmaterialien oder Quartzglas ausgebildet sein oder solche Materialien aufweisen. Die Deckelfläche 123 und die Trenneinrichtung 120 können vorteilhaft auch aus einem einzigen Keramikgussteil hergestellt werden, wobei ein "Grünling" in der benötigten Form abgegossen, geformt, und anschließend gesintert wird. Es können auch einzelne Keramikteile zum Formen der Trenneinrichtung 120 und/oder der Deckfläche 123 miteinander verschweißt werden. Die Deckfläche 123 kann weiterhin auch als Flansch von beispielsweise Aluminium oder Edelstahl ausgebildet sein. Die Keramikteile können mittels einer Verschlussfläche 125, welche den dritten Hohlzylinder an seinem von der Ätzkammer 150 abgewandten axialen Ende verschließt und welche als Flansch ausgebildet sein kann, an die erste Einleitung 107 angebunden werden. Der Flansch kann beispielsweise aus Aluminium oder Edelstahl ausgebildet sein. Es können Dichtungen verwendet werden an allen Stellen, wo eine Gasdichtigkeit erforderlich ist.

Mittels einer ersten Einleitung 107, welche im Zentrum der den dritten Hohlzylinder H3 axial einseitig verschließenden Verschlussfläche 125 angeordnet ist, ist ein erstes Gas G1 aus einem ersten Gastank 105 in die erste Reaktionskammer leitbar. In der zweiten Reaktionskammer 102 ist ein der Form der zweiten Reaktionskammer 102 angepasster, gemäß der ersten Ausführungsform somit kreisförmiger Gasverteilerring 104 angeordnet, welcher die Trenneinrichtung 120 tangential umschließt, wobei der Gasverteilerring 104 sowohl von der Mantelfläche 122 als auch von der Trenneinrichtung 120 beabstandet ist. Der Gasverteilerring 104 ist rotationssymmetrisch um die virtuelle Achse A und konzentrisch mit dem zweiten und dem vierten Hohlzylinder H2, H4 angeordnet. Mittels einer zweiten Einleitung 108 ist ein zweites Gas G2 aus einem zweiten Gastank 106 in den Gasverteilerring 104 lenkbar, wodurch das Gas G2 über den gesamten Umfang der zweiten Reaktionskammer 102 hinweg gleichmäßig in die zweite Reaktionskammer 102 einleitbar ist. Zusätzlich oder alternativ zu dem Gasverteilerring 104 kann das Einleiten des zweiten Gases G2 in die zweite Reaktionskammer 102 auch mittels radial in der Mantelfläche 122 des zweiten Hohlzylinders H2 oder in der Deckfläche 123 angeordneten Gaseinlässen erfolgen, welche vorteilhafterweise eine Cₙ-Symmetriegruppe aufweisen, beispielsweise C₃, C₄ etc.

Außerhalb des dritten Hohlzylinders H3, diesen tangential umschließend, ist eine erste induktive Spule 110 angeordnet. Außerhalb des zweiten Hohlzylinders H3, diesen tangential umschließend, ist eine zweite induktive Spule 112 angeordnet. Beide induktiven Spulen 110, 112 sind rotationssymmetrisch um die virtuelle Achse A.

Mittels der ersten Spule 110, durch Erzeugen eines ersten elektromagnetischen Wechselfelds in der ersten Reaktionskammer 101, ist das erste Gas G1 in der ersten Reaktionskammer 101 zu einem ersten induktiv gekoppelten Plasma anregbar. Beispielsweise ist Octafluorcyclobutan (mit der Strukturformel c-C₄F₈, ein Passiviergas) als erstes Gas G1 in die erste Reaktionskammer 101 einleitbar. In dem erzeugten hochdichten ersten Plasma in der ersten Reaktionskammer 101 werden durch Plasmapolymerisation Teflon-bildende erste reaktive Spezies R1 gebildet, welche vorzugsweise langkettige Moleküle aufweisen. Längere Polymerketten führen im Regelfall zu einer weicheren, loser vernetzten Filmmorphologie eines Teflonfilms auf dem zu ätzenden Substrat 152. Das Entfernen eines solchen Teflonfilms von dem Ätzgrund erfordert eine geringere loneneinwirkung als das Entfernen eines durch kürzere Polymerketten gebildeten Teflonfilms. Dadurch ist der Ätzprozess insgesamt eher chemisch dominiert als physikalisch, das heißt, eher durch spontane Ätzreaktionen der Fluorradikale auf dem Ätzgrund als durch loneneinwirkung. Hierdurch ergeben sich vorteilhaft hohe Ätzraten und eine hohe Selektivität zur Maske. Die Kondensation der Teflon-bildenden reaktiven Spezies auf dem Wafer kann vorteilhaft durch Wahl einer geeigneten Temperierung des Substrats 152 erfolgen, beispielsweise durch die Temperierungseinrichtung.

Mittels der zweiten Spule 112, durch Erzeugen eines zweiten elektromagnetischen Wechselfelds in der zweiten Reaktionskammer 102, ist das zweite Gas G2 in der zweiten Reaktionskammer 102 zu einem zweiten induktiv gekoppelten Plasma anregbar. Beispielsweise ist Schwefelhexafluorid (mit der Strukturformel SF₆, ein Ätzgas) als zweites Gas in die zweite Reaktionskammer 102 einleitbar. In dem erzeugten hochdichten zweiten Plasma werden somit Fluorradikale als zweite reaktive Spezies R2 erzeugt. Die erste und die zweite Spule 112 werden dazu über eine elektrische Anpassungseinrichtung 114 (englisch: "matching unit" oder "matchbox", im Deutschen auch Hochfrequenzanpassungsnetzwerke genannt), welche mit einer Hochfrequenz-Generatoreinrichtung 116 elektrisch verbunden sind, zum Beaufschlagen der ersten und der zweiten Reaktionskammer 101, 102 mit einem jeweiligen elektromagnetischen Wechselfeld, gespeist. Eine lonenbeschleunigung, also eine Beschleunigung von in den Plasmen erzeugten geladenen Teilchen, sogenannten Ionen auf das zu ätzende Substrat 152 hin, ist durch das Beaufschlagen des Trägers 155 mit der ersten Hochfrequenz-Wechselspannung erzielbar.

Auf dem Weg von der ersten und zweiten Reaktionskammer 101, 102 treten die beiden reaktiven Spezies R1, R2 in die Vermengungseinrichtung 130, 132 ein, welche zur besseren Vermengung der ersten und zweiten reaktiven Spezies R1, R2 ausgebildet ist. Die Vermengungseinrichtung 130, 132 umfasst eine sich in Richtung der Ätzkammer 150 trichterförmig verjüngende, hohlkegelstumpfförmige Führungseinrichtung 130 zum Führen der miteinander vermengten ersten reaktiven Spezies R1 und zweiten reaktiven Spezies R2 auf das Substrat 152 hin. Die Vermengungseinrichtung 130, 132 ist vorteilhafterweise aus einem dielektrischen Material gefertigt, wobei auch eine Fertigung aus Metall denkbar ist.

Weiterhin umfasst die Vermengungseinrichtung 130, 132 eine räumlich zwischen der ersten Reaktionskammer 101 und der Ätzkammer 150 angeordnete Umleitungseinrichtung 132 zum Umleiten mindestens eines Teils der ersten reaktiven Spezies R1. Mittels der Umleitungseinrichtung 132 ist ein direkter Weg der ersten reaktiven Spezies R1 aus der ersten Reaktionskammer R1 zu dem Substrat 152 vollständig versperrt. Die Umleitungseinrichtung 132 ist eine rotationssymmetrisch um die virtuelle Achse A angeordnete Prallplatte und weist in einer Ebene, in welcher die virtuelle Achse A liegt, einen trapezförmigen, sich in Richtung der Ätzkammer 150 verbreiternden Querschnitt auf. Mittels der Umleitungseinrichtung 132 werden die ersten reaktiven Spezies R1 in, auf die virtuelle Achse A bezogen, radialer Richtung nach außen in einen Strom der zweiten reaktiven Spezies R2 hinein gelenkt, wodurch die Vermengung der ersten und zweiten reaktiven Spezies R1, R2 verbessert wird. Durch eine Öffnung 131 in der Führungseinrichtung 130 treten die miteinander vermengten ersten und zweiten reaktiven Spezies R1, R2 in die Ätzkammer 150 ein und werden auf das Substrat 152 hin gerichtet und/oder kanalisiert.

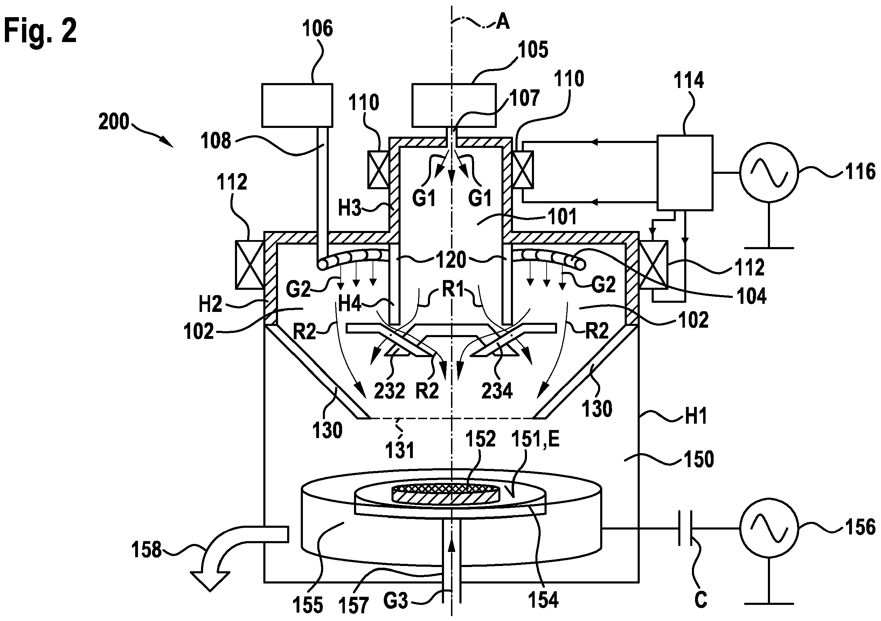

Fig. 2 zeigt eine schematische Querschnittsansicht durch eine Vorrichtung 200 zum anisotropen Ätzen eines Substrats 152 gemäß einer zweiten Ausführungsform der vorliegenden Erfindung. Die Vorrichtung 200 gemäß der zweiten Ausführungsform ist eine Variante der Vorrichtung 100 gemäß der ersten Ausführungsform und unterscheidet sich von dieser in der Ausbildung der Vermengungseinrichtung 130, 232, 234.

Anstelle der Umleitungseinrichtung 132 weist die Vermengungseinrichtung 130, 232, 234 gemäß der zweiten Ausführungsform eine erste Umleitungseinrichtung 232 und eine zweite Umleitungseinrichtung 234 auf. Die erste Umleitungseinrichtung 232 ist eine Variante der Umleitungseinrichtung 132, welche statt einer Rotationssymmetrie eine Cₙ-Symmetrie um die virtuelle Achse A aufweist, da im Gegensatz zu dem Umleitungselement 132 einzelne Kreissegmente aus dem - aus axialer Richtung der virtuellen Achse A betrachteten - Querschnitt der ersten Umleitungseinrichtung 232 entfernt sind. In jede durch das Entfernen der Kreissegmente entstandene Lücke greift jeweils passend ein Kreissegment der zweiten Umleitungseinrichtung 234 ein. Die zweite Umleitungseinrichtung 234 ist in der Grundform ein um die virtuelle Achse A rotationssymmetrischer, sich in Richtung der Ätzkammer 150 verjüngender hohlkegelstumpfförmiger Trichter, welcher statt einer Rotationssymmetrie eine Cₙ-Symmetrie aufweist, da aus dem - aus axialer Richtung der virtuelle Achse A betrachteten - Querschnitt des zweiten Umleitungselements 232 ebenfalls Kreissegmente entfernt sind. In jede durch das Entfernen der Kreissegmente aus der zweiten Umleitungseinrichtung 232 entstehende Lücke greift passend ein Kreissegment der ersten Umleitungseinrichtung 232 ein und umgekehrt. Die Kreissegmente der ersten und/oder der zweiten Umleitungseinrichtung 232, 234 sind bevorzugt als Viertel-, Sechstel-, Achtel-, Zehntel-, Zwölftel-Kreissegmente etc. ausgebildet. Das heißt, die erste und/oder die zweite Umleitungseinrichtung 232, 234 weisen bevorzugt eine C₂ₘ-Symmetrie bezüglich der virtuelle Achse A auf, wobei m eine ganze Zahl ist, vorzugsweise eine ganze Zahl zwischen eins und sechs.

Mittels der zweiten Umleitungseinrichtung 234 wird ein Teil der erzeugten zweiten reaktiven Spezies R2 zwischen der Trenneinrichtung 120 und dem zweiten Umleitungselement 234 in radialer Richtung zu der virtuelle Achse A hin durch die Lücken in der ersten Umleitungseinrichtung 232 geleitet. Mittels der ersten Umleitungseinrichtung 232 wird ein Teil der erzeugten ersten reaktiven Spezies R1 zwischen der Trenneinrichtung 120 und der ersten Umleitungseinrichtung 232 in radialer Richtung von der virtuelle Achse A fort durch die Lücken in dem zweiten Umleitungselement 234 geleitet. Hierdurch ist die Vermengung der beiden reaktiven Spezies R1, R2 auf dem Weg von den beiden Reaktionskammern 101, 102 zu dem Substrat 152 verbessert.

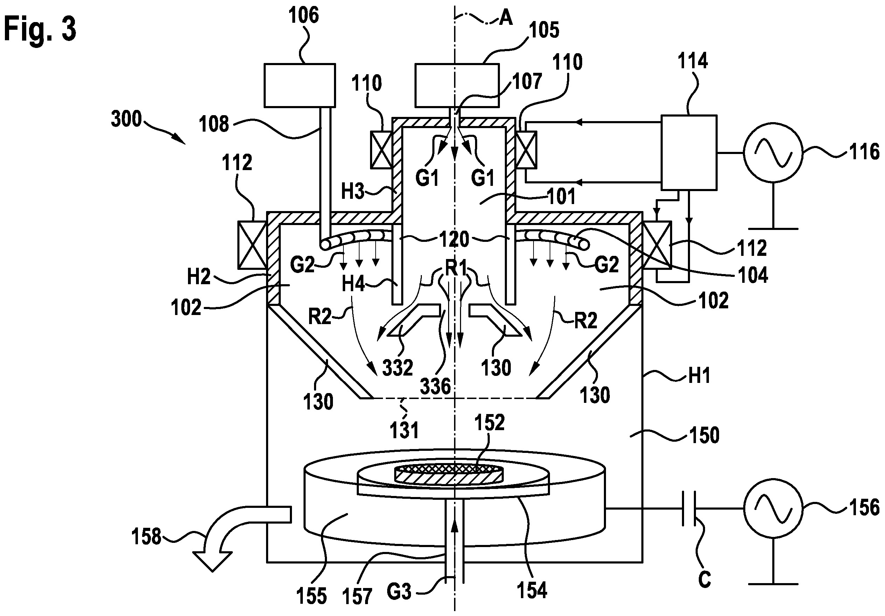

Fig. 3 zeigt eine schematische Querschnittsansicht durch eine Vorrichtung 300 zum anisotropen Ätzen eines Substrats 152 gemäß einer dritten Ausführungsform der vorliegenden Erfindung. Die Vorrichtung 300 gemäß der dritten Ausführungsform ist eine Variante der Vorrichtung 100 gemäß der ersten Ausführungsform und unterscheidet sich von dieser in der Ausbildung der Vermengungseinrichtung 130, 332.

Die Umleitungseinrichtung 332 gemäß der dritten Ausführungsform ist eine Variante der Umleitungseinrichtung 132 gemäß der ersten Ausführungsform und weist im Vergleich zu diesem weiterhin eine Öffnung 336 im Bereich der virtuellen Achse A auf, durch welche sich die erzeugten ersten reaktiven Spezies R1 zumindest teilweise auf einem direkten Weg von der Reaktionskammer 1 zu dem Substrat 152 bewegen können. Insbesondere befindet sich von der Mündung der ersten Einleitung 107 bis zu dem Träger 155 für das Substrat 152 kein bauliches Hindernis entlang der virtuellen Achse A. Die Öffnung 336 in der Umleitungseinrichtung 332 ist vorzugsweise elliptisch, insbesondere kreisförmig und rotationssymmetrisch um die virtuelle Achse A.

Die Vorrichtung gemäß der dritten Ausführungsform eignet sich besonders für die oben beschriebene Weiterbildung, wonach zwischen dem ersten und dem zweiten Gastank 105, 106 und der ersten und zweiten Einleitung 107, 108 zwei Dreiwegeventile angeordnet sind, sodass in sowohl die erste als auch die zweite Reaktionskammer 101, 102 Gase aus dem ersten sowie aus dem zweiten Gastank 105, 106, insbesondere abwechselnd, einleitbar sind.

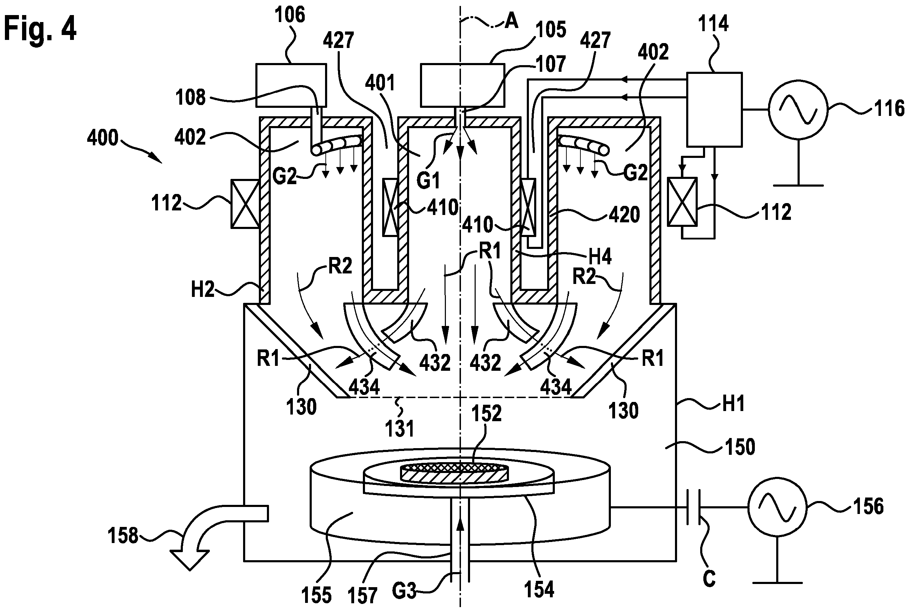

Fig. 4 zeigt eine schematische Querschnittsansicht durch eine Vorrichtung 400 zum anisotropen Ätzen eines Substrats 152 gemäß einer vierten Ausführungsform der vorliegenden Erfindung. Die Vorrichtung 400 gemäß der vierten Ausführungsform ist eine Variante der Vorrichtung 100 gemäß der ersten Ausführungsform und unterscheidet sich von dieser in der Form und/oder der Anordnung der ersten Reaktionskammer 401, der zweiten Reaktionskammer 402, der Vermengungseinrichtung 430, 432, 434 sowie der ersten induktiven Spule 410 und der zweiten induktiven Spule 112. Die erste induktive Spule 410 ist tangential auf den Hohlzylinder H4 angebracht und sitzt in einem Spalt zwischen die Trennwände 420 bildenden Einzelwänden. Die induktive Spule 410 erzeugt maßgeblich das erste Plasma in der ersten Reaktionskammer 401 und trägt zusätzlich zur Plasmaentladung in der zweiten Reaktionskammer 402 mit bei. Die Hauptanregung des zweiten Plasmas in der zweiten Reaktionskammer 402 erfolgt durch die zweite induktive Spule 112.

Die Vorrichtung 400 gemäß der vierten Ausführungsform weist keinen dritten Hohlzylinder H3 auf, welcher aus einer den zweiten Hohlzylinder H2, in axialer Richtung, an einem Ende verschließenden Deckelfläche extrudiert ist. Stattdessen schließt der die Trenneinrichtung 420 bildende vierte Hohlzylinder H4 der Vorrichtung 400 in axialer Richtung an beiden Enden mit den axialen Enden des zweiten Hohlzylinders H2 bündig ab. Mit anderen Worten umfasst die erste Reaktionskammer 401 als Volumen das Produkt aus der Höhe h4 des vierten Hohlzylinders, der Kreiszahl Pi und dem Quadrat des Zylinderradius r1.

Gemäß der vierten Ausführungsform ist die erste induktive Spule 410 auf der Mantelfläche des vierten Hohlzylinders H4 in dem Spalt zwischen den Trennwänden 420, angeordnet. Die Speisung der ersten induktiven Spule 410 erfolgt durch elektrische Zuführungen von der ersten Spule 410 zu der Anpassungseinrichtung 114. Die elektrischen Zuführungen verlaufen ebenfalls in dem Spalt zwischen den die Trenneinrichtung 420 bildenden Einzelwände.

Die Vermengungseinrichtung 130, 432, 434 der Vorrichtung 400 weist neben der Führungseinrichtung 130 eine erste Umleitungseinrichtung 432 auf, welche an dem der Ätzkammer 150 zugewandten axialen Ende des vierten Hohlzylinders H4 angeordnet ist. Die Vermengungseinrichtung 130, 432, 434 weist weiterhin eine zweite Umleitungseinrichtung 434 auf, welche an dem der Ätzkammer 150 zugewandten axialen Ende des zweiten Hohlzylinders H2 angeordnet ist. Die beiden Umleitungseinrichtungen 432, 434 können an der Trenneinrichtung 420 befestigt sein oder mit dieser einstückig ausgebildet sein.

Die erste Umleitungseinrichtung 432 umfasst eine Vielzahl von Rohrstücken, welche dazu ausgebildet sind, jeweils einen Teil der erzeugten ersten reaktiven Spezies R1 in radialer Richtung von der virtuelle Achse A fort, insbesondere zusätzlich in Richtung zu dem Träger 155, zu leiten. Die zweite Umleitungseinrichtung 434 umfasst eine Vielzahl von Rohrstücken, welche jeweils einen Teil der erzeugten zweiten reaktiven Spezies R2 in radialer Richtung zu der virtuelle Achse A hin, insbesondere zusätzlich in Richtung zu dem Träger 155, leiten.

Die zu der virtuelle Achse A leitenden Rohrstücke der ersten Umleitungseinrichtung 432 und die von der virtuelle Achse A fort leitenden Rohrstücke der zweiten Umleitungseinrichtung 434 wechseln sich dabei entlang eines Umfangs eines virtuellen, mit der virtuelle Achse A konzentrischen und auf der virtuellen Achse A senkrecht stehenden Kreises ab. Die erste und die zweite Umleitungseinrichtung 432, 434 können, gemeinsam oder jede für sich, bezüglich der virtuelle Achse A eine Cₙ-Symmetriegruppe aufweisen. Anstelle der Rohrstücke können auch Halbrohrstücke, das heißt längs aufgeschnittene Rohrstücke, oder andere Direktoren entsprechend der beschriebenen Anordnung eingesetzt werden.

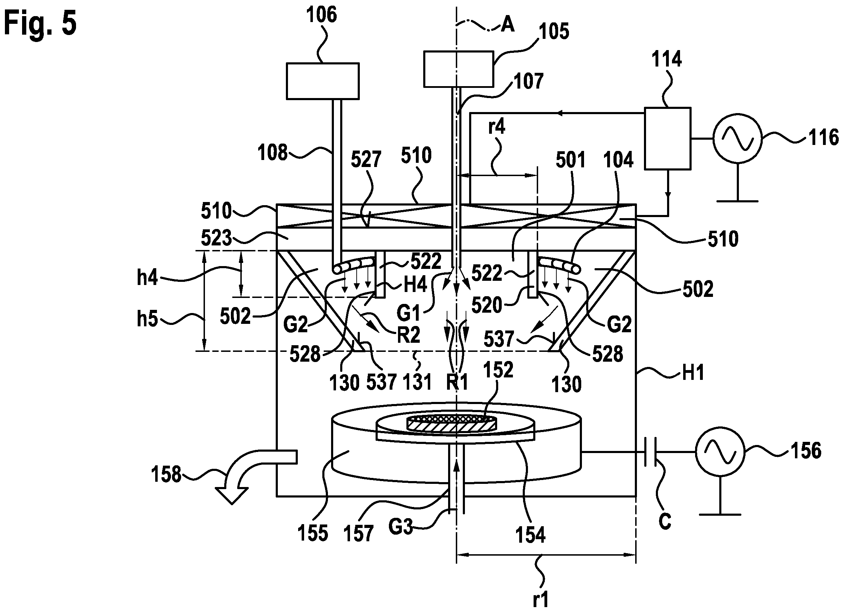

Fig. 5 zeigt eine schematische Querschnittsansicht durch eine Vorrichtung 500 zum anisotropen Ätzen eines Substrats 152 gemäß einer fünften Ausführungsform der vorliegenden Erfindung. Die Vorrichtung 500 gemäß der fünften Ausführungsform ist eine Variante der Vorrichtung 400 gemäß der vierten Ausführungsform und unterscheidet sich von dieser insbesondere in der Form und/oder der Anordnung der zweiten Reaktionskammer 502, der Vermengungseinrichtung 130 sowie der induktiven Spule 510.

Die Vorrichtung 500 weist keinen zweiten Hohlzylinder H2 auf, welcher auf den ersten Hohlzylinder H1 aufgesetzt ist, sondern weist stattdessen eine flache dielektrische Deckelplatte 523, beispielsweise aus einer Aluminiumoxid-Keramik oder aus Quartzglas, auf, mittels welcher der erste Hohlzylinder H1 an einem axialen Ende verschlossen ist. Ein dielektrischer Hohlzylinder H4 ist geeignet an der Deckelplatte befestigt oder daran aufgehängt. Unterhalb der Deckelplatte 523 schließt sich, die Führungseinrichtung 130 an. Die Führungseinrichtung 130 verjüngt sich, in einer Richtung von der Deckelplatte 523 hin zu dem Träger 155, trichterförmig von einem Kreisradius gleich dem Zylinderradius r1 des ersten Hohlzylinders H1 zu einem kleineren Kreisradius, der beispielsweise gleich dem Zylinderradius r4 des vierten Hohlzylinders H4 sein kann.

Sowohl Hinblick auf ihre Ausdehnung in axialer Richtung als auch im Hinblick auf ihre Ausdehnung in radialer Richtung, jeweils bezogen auf die virtuelle Achse A, sind die erste Reaktionskammer 501 und die zweite Reaktionskammer 502 von der Führungseinrichtung 130 umschlossen. Insbesondere ist die Höhe h4 des vierten Hohlzylinders H4 geringer als eine Höhe h5, in axialer Richtung, der hohlkegelstumpfförmigen Führungseinrichtung 130. Die zweite Reaktionskammer 502 umfasst ein Volumen zwischen einer Innenfläche 537 der Führungseinrichtung 130 und einer Außenfläche 528 der Mantelfläche 522 des vierten Hohlzylinders H4.

Statt der ersten und zweiten induktiven Spulen 410, 412 weist die Vorrichtung 500 nur eine einzige, als spiralförmige Flachspule ausgebildete induktive Spule 510 auf. Die induktive Spule 510 ist auf, insbesondere an einer von der Ätzkammer 150 abgewandten externen Oberfläche 527 der dielektrischen Deckelfläche 523 angeordnet, wobei für die beiden Einleitungen 107, 108 Durchlässe durch die Spule 510 vorgesehen sein können. Die Spule 510 kann als eine durchgehende spiralförmige Spule ausgeführt sein. Die Spule 510 kann aber auch in eine innere und eine äußere spiralförmige Teilspule L1, L2 unterteilt sein, welche auch unabhängig voneinander mittels der Anpassungseinrichtung 114 speisbar sind. Dabei kann die innere Teilspule L1 zum Beaufschlagen der ersten Reaktionskammer 501 mit einem ersten elektromagnetischen Wechselfeld ausgebildet sein und die äußere Teilspule L2 zum Beaufschlagen der zweiten Reaktionskammer 502 mit einem zweiten elektromagnetischen Wechselfeld ausgebildet sein.

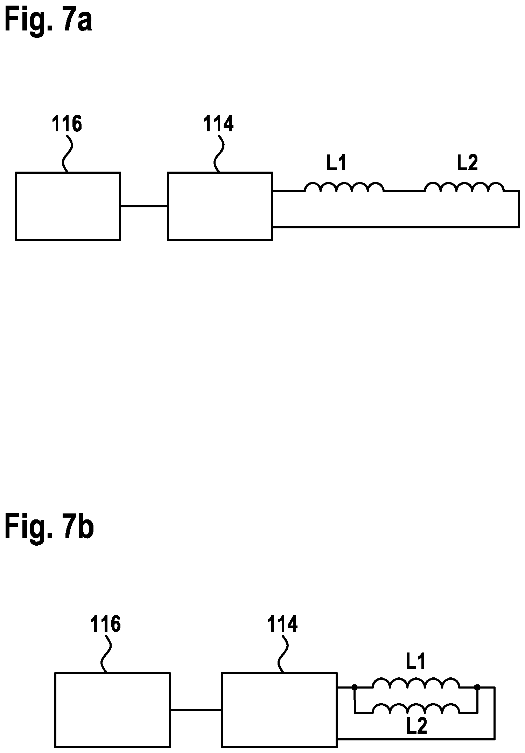

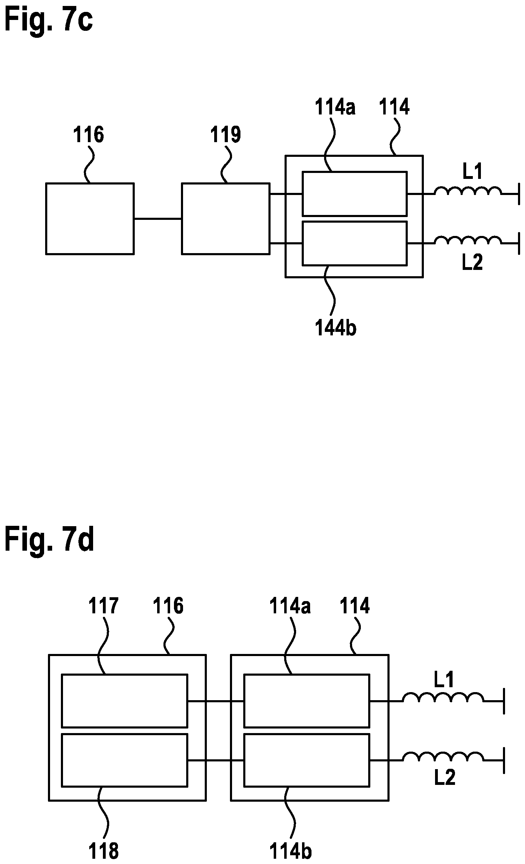

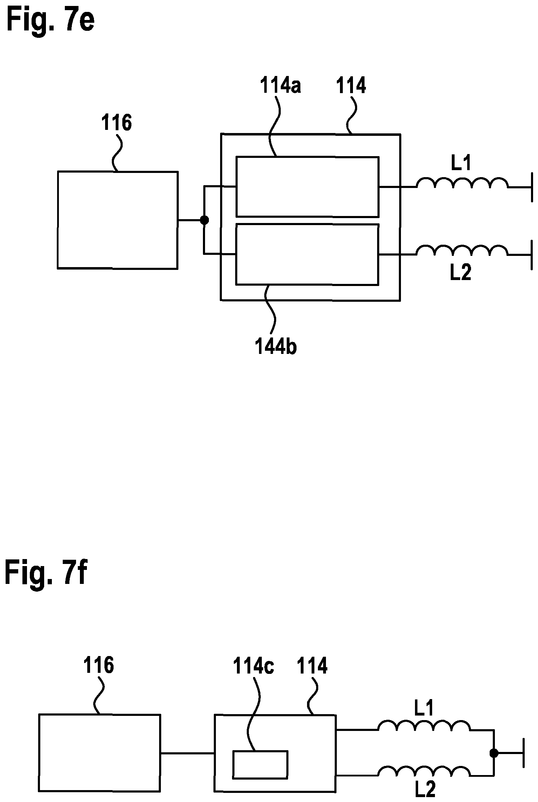

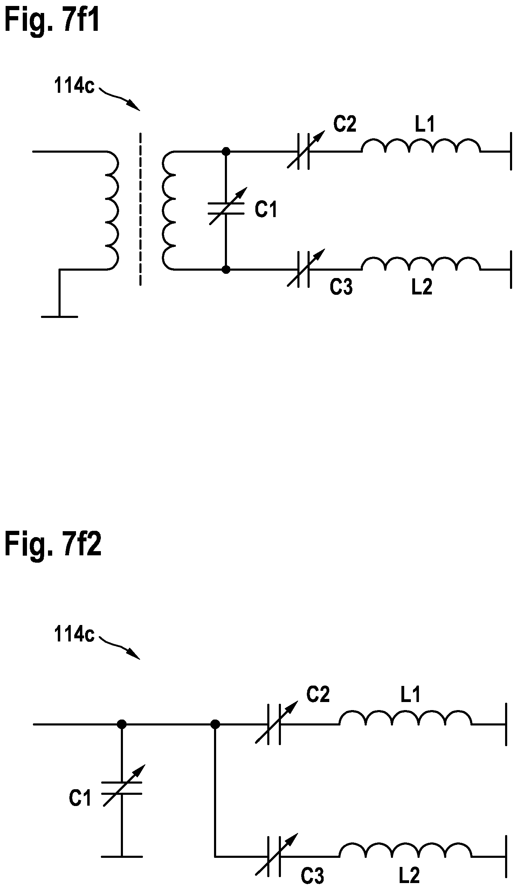

Fig. 7a bis 7f2 zeigen verschiedene Gestaltungsformen, wie eine erste Teilspule L1 und eine zweite Teilspule L2 über eine Anpassungseinrichtung 114, welche gegebenenfalls zwei Teil-Anpassungseinrichtungen 114a, 114b aufweist, mit der Hochfrequenz-Generatoreinrichtung 116 verschaltbar und somit speisbar sind. Die Hochfrequenz-Generatoreinrichtung kann einen oder zwei voneinander separate und unabhängige Hochfrequenz-Wechselspannungsgeratoren 117, 118 umfassen. In Fig. 7c wird zusätzlich ein Hochfrequenz-Splitter 119 eingesetzt. Die Figuren 7f1 und 7f2 zeigen alternative Gestaltungsformen für die in Fig. 7f gezeigte Anpassungsschaltung 114c der Anpassungseinrichtung 114. Die Anpassungsschaltung 114c weist drei Kondensatoren C1, C2, C3 mit jeweils einstellbarer elektrischer Kapazität auf.

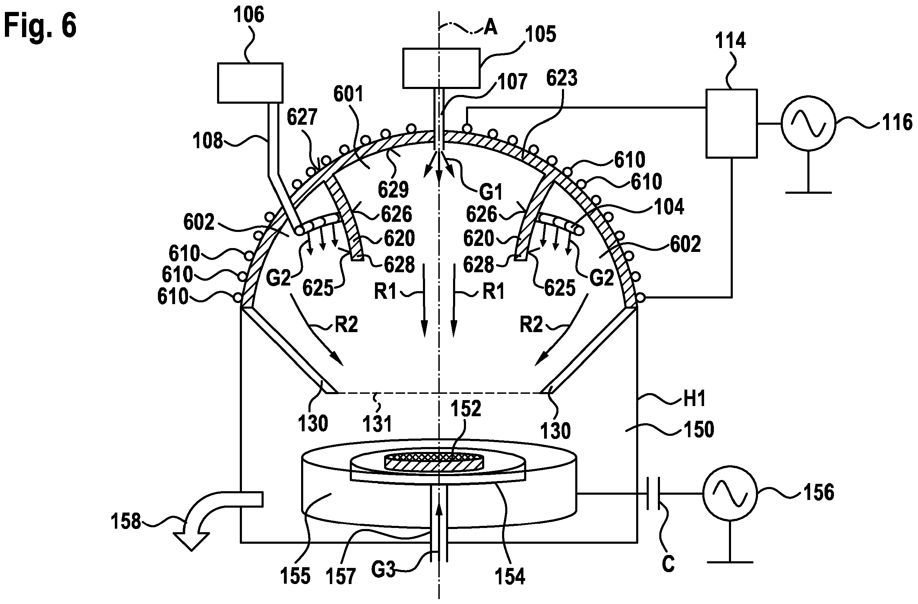

Fig. 6 zeigt eine schematische Querschnittsansicht durch eine Vorrichtung 600 zum anisotropen Ätzen eines Substrats 152 gemäß einer sechsten Ausführungsform der vorliegenden Erfindung. Die Vorrichtung 600 gemäß der sechsten Ausführungsform ist eine Variante der Vorrichtung 500 gemäß der fünften Ausführungsform und unterscheidet sich von dieser insbesondere in der Form der ersten und zweiten Reaktionskammern 601, der Vermengungseinrichtung 130 und der induktiven Spule 610.

Gemäß der Vorrichtung 600 ist statt der flachen dielektrischen Deckelplatte 523 zum Abdecken des ersten Hohlzylinders H1 eine dielektrische Deckelkuppel 623 vorgesehen, welche beispielsweise aus einer Aluminiumoxid-Keramik oder aus Quartzglas ausgebildet ist. Zum Unterteilen des außerhalb des ersten Hohlzylinders H1 gelegenen, von der Deckelkuppel 623 umschlossenen Volumens in eine erste und eine zweite Reaktionskammer 601, 602, ist an einer internen Oberfläche 629 der Deckelkuppel 623, welche der Ätzkammer 150 zugewandt ist, eine um die virtuelle Achse A rotationssymmetrische Trenneinrichtung 620 ausgebildet bzw. an der Deckelkuppel 623 geeignet befestigt oder daran aufgehängt.

Die Trenneinrichtung 620 weist sich in Richtung der Ätzkammer 150 erstreckende, in Bezug auf die virtuelle Achse A konkav gekrümmte Trennwände 628 auf. Die Trennwände können einstückig mit der Deckelkuppel 623 ausgebildet, aber auch an der Deckelkuppel 623 angebracht sein, beispielsweise mittels Schweißens oder Aufhängens. Die erste Reaktionskammer 601 umfasst das Volumen innerhalb einer Innenfläche 262 der Trennwände 628 der Trenneinrichtung 620. Die zweite Reaktionskammer 602 umfasst das Volumen, welches sowohl außerhalb einer Außenfläche 625 der Trennwände 628 der Trenneinrichtung 620 als auch innerhalb der internen Oberfläche 629 der Deckelkuppel 623 positioniert ist.

Bei der Vorrichtung 600 liegen die beiden Reaktionskammer 601, 602 vollständig außerhalb des ersten Hohlzylinders H1, während die Führungseinrichtung 130 vollständig innerhalb des ersten Hohlzylinders H1 angeordnet ist.

Die induktive Spule 610 ist, wie die induktive Spule 510 gemäß der fünften Ausführungsform, spiralförmig ausgebildet, allerdings im Gegensatz zu der Spule 510 nicht flach, sondern kuppelförmig entlang einer externen Oberfläche 627 der Deckelkuppel 623, wobei die externe Oberfläche 627 von der Ätzkammer 150 abgewandt ist.

Die Spule 610 kann, wie auch die Spule 510, als durchgehende Spule ausgeführt, aber auch in eine innere und eine äußere Teilspule L1, L2 unterteilt sein, welche auch unabhängig voneinander mittels der Anpassungseinrichtung 114 speisbar sind. Dabei kann die innere Teilspule L1 zum Beaufschlagen der ersten Reaktionskammer 601 mit dem ersten elektromagnetischen Wechselfeld ausgebildet sein und die äußere Teilspule L2 zum Beaufschlagen der zweiten Reaktionskammer 602 mit dem zweiten elektromagnetischen Wechselfeld ausgebildet sein. Die innere und die äußere Teilspule L1, L2 und die Anpassungseinrichtung 114 können beispielsweise gemäß in den Fig. 7a bis 7f2 gezeigten Gestaltungsformen ausgebildet und z.B. separat und unabhängig voneinander mit Hochfrequenzleistung speisbar sein.

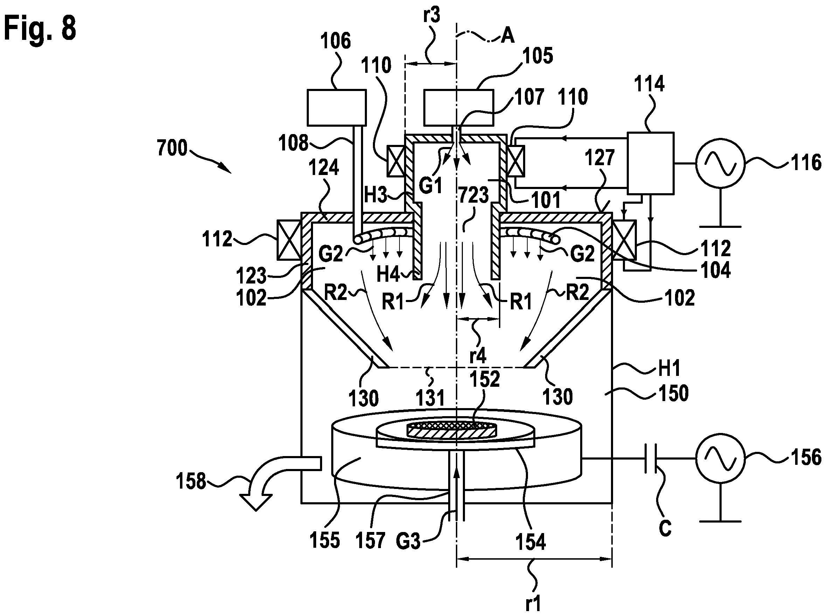

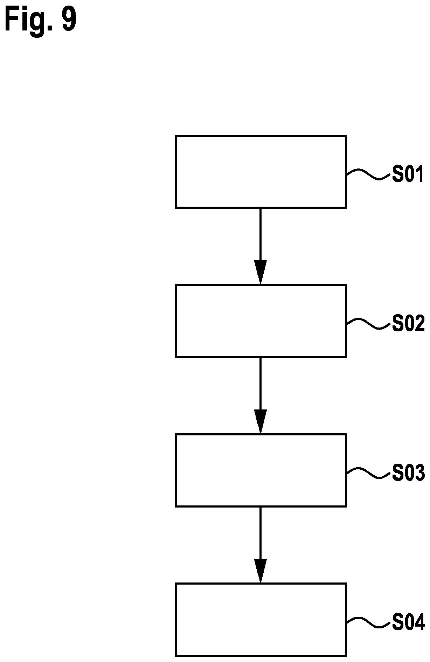

Fig. 8 zeigt eine schematische Querschnittsansicht durch eine Vorrichtung 700 zum anisotropen Ätzen eines Substrats 152 gemäß einer siebten Ausführungsform der vorliegenden Erfindung.

Fig. 8 zeigt eine schematische Querschnittsansicht durch eine Vorrichtung 700 zum anisotropen Ätzen eines Substrats 152 gemäß einer siebten Ausführungsform der vorliegenden Erfindung. Die Vorrichtung 700 gemäß der siebten Ausführungsform ist eine Variante der Vorrichtung 100 gemäß der ersten Ausführungsform und unterscheidet sich von dieser in der Form der Vermengungseinrichtung 130, sowie des dritten Hohlzylinders H3 und des vierten Hohlzylinders H4.

Gemäß der siebten Ausführungsform sind der dritte Hohlzylinder H3 und der vierte Hohlzylinder H4 einstückig ausgebildet oder zusammengesetzt und in eine kreisförmige, um die virtuelle Achse A rotationssymmetrische Öffnung 723 in der Kreisringscheibe 124 derart eingesetzt, dass der vierte Hohlzylinder H4 zum Trennen der ersten und der zweiten Reaktionskammer 101, 102 durch die Kreisringschreibe 124 hindurchragt, während der dritte Hohlzylinder H3 teilweise an einer externen, von der Ätzkammer 150 abgewandten Oberfläche 127 der Kreisringscheibe 124 dichtend anliegt. Weiterhin ist gemäß der siebten Ausführungsform der Zylinderradius r3 des dritten Hohlzylinders H3 größer als der Zylinderradius r4 des vierten Hohlzylinders H4, welche beide kleiner sind als der Zylinderradius r1 des ersten Hohlzylinders H1. Die Vorrichtung 700 weist nur die Führungseinrichtung 130 als Vermengungseinrichtung auf. In einer nicht gezeigten Variante der siebten Ausführungsform kann der vierte Hohlzylinder H4 auch komplett entfallen, d.h. die Trennung der beiden reaktiven Spezies im Bereich der zweiten Reaktionskammer 102 erfolgt somit ausschließlich über die räumliche Distanz zwischen dem Gasaustritt aus dem Kessel, welchen der dritte Hohlzylinder H3 bildet, einerseits und der zweiten induktiven Spule 112 bzw. der zweiten Reaktionskammer 102 andererseits, bzw. durch Trennung der Gasströmungen aus dem Gasverteilerring 104 einerseits und dem dritten Hohlzylinder H3 andererseits, bzw. durch die Kinetik der zunächst getrennt strömenden Gase bzw. Spezies.

Die Vorrichtung 700 gemäß der siebten Ausführungsform kann beispielsweise mit dem folgenden ersten Parameterset betrieben werden: einem Druck in den Reaktionskammern 101, 102 und der Ätzkammer 150 von zwischen drei und zwanzig Pascal, vorzugsweise zwischen sechs und acht Pascal, besonders bevorzugt sechseinhalb Pascal; einer an der ersten induktiven Spule 110 anliegenden Leistung von zweitausendfünfhundert Watt; einer an der zweiten induktiven Spule 112 anliegenden Leistung von eintausendsiebenhundert Watt; einer an dem Träger 155 anliegenden Wechselspannung mit einer Leistung von fünfzig Watt und einer Frequenz von 13.56 Megahertz; einem Druck des Heliumgases in der Kühlzuleitung 157 von zwischen ein und drei Pascal, vorzugsweise 2 Pascal; einer Temperatur des Trägers 155 von fünfundzwanzig Grad Celsius; Octafluorcyclobutan als erstem Gas G1 mit einem Fluss durch die erste Einleitung 107 von zweihundert Standardkubikzentimeter pro Minute; und Schwelhexafluorid als zweitem Gas G2 mit einem Fluss durch die zweite Einleitung 108 von fünfhundert Standardkubikzentimeter pro Minute. Der Standardkubikzentimeter ist ein Gasvolumen von einem Kubikzentimeter unter den sogenannten physikalischen Normbedingungen nach DIN 1343 und ist über die Normdichte etwa in einen Molfluss pro Sekunde umrechenbar.

Ein zweites Parameterset, mit welchem die Vorrichtung 700 gemäß der siebten Ausführungsform betreibbar ist, unterscheidet sich von dem ersten Parameterset darin, dass die an dem Träger 155 angelegte Wechselspannung eine Leistung von fünfundzwanzig Watt aufweist und die Temperatur des Trägers 155 fünfzig Grad Celsius beträgt bzw. darauf temperiert wird.

Fig. 8 zeigt ein schematisches Flussdiagramm zum Erläutern eines Verfahrens zum Betreiben einer erfindungsgemäßen Vorrichtung 100; 200; 300, 400, 500; 600; 700.

In einem Schritt S01 wird das erste Gas G1 in die erste Reaktionskammer 101; 401; 501; 601 eingeleitet. In einem Schritt S02 wird das zweite Gas G2 in die zweite Reaktionskammer 102; 402; 502; 602 eingeleitet, und zwar gleichzeitig mit dem Einleiten des ersten Gases G1 in die erste Reaktionskammer 101; 401; 501; 601. In einem Schritt S03 wird mindestens ein elektromagnetisches Wechselfeld zum Erzeugen der reaktiven Spezies R1 aus dem ersten Gas G1 und zum Erzeugen der zweiten reaktiven Spezies R2 aus dem zweiten Gas G2 erzeugt. In einem Schritt S04 wird an den Träger 155 die erste Hochfrequenz-Wechselspannung zum Beschleunigen der in den Plasmazonen erzeugten elektrisch geladenen Teilchen, der sogenannten Ionen, auf das Substrat 152 hin angelegt.

Details zu dem erfindungsgemäßen Verfahren und zu dessen bevorzugten Weiterbildungen sind auch den obigen Beschreibungen der erfindungsgemäßen Vorrichtung und deren bevorzugten Weiterbildungen und Varianten entnehmbar. Das erfindungsgemäße Verfahren ist zum Durchführen mit jeder Ausführungsform der Vorrichtung entsprechend anpassbar.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne vom Kern der Erfindung abzuweichen. Beispielsweise können die anhand von verschiedenen Ausführungsformen beschriebenen Vermengungseinrichtungen und deren Umleitungseinrichtungen auch miteinander kombiniert oder durch einander ersetzt werden. Insbesondere können unterschiedliche Plasmaquellen- bzw. Kesselanordnungen mit beliebigen Vermengungseinrichtungen kombiniert werden, abweichend von den gezeigten Ausführungsbeispielen. Ebenso kann als einfachste Variante einer Vermengungseinrichtung eine bloße Diffusionsstrecke zwischen den Plasmaquellen und dem Ort des Siliziumwafers dienen. Dabei ist mit Diffusionsstrecke eine Wegstrecke gemeint, über die die beiden Gase bzw. reaktiven Spezies nach Verlassen ihrer Erzeugungsbereiche gemeinsam in Richtung des Substrats, das heißt der Ätzkammer, strömen, wobei ein Vermischen der beiden reaktiven Spezies durch Interdiffusionsprozesse entlang dieses Weges erfolgt.

## Patentansprüche

1. Vorrichtung zum anisotropen Ätzen eines Substrats, mit
einer ersten Reaktionskammer (101; 401; 501; 601), in welche ein erstes Gas (G1) einleitbar ist;
einer zweiten Reaktionskammer (102; 402; 502; 602), in welche ein zweites Gas (G2) einleitbar ist;
mindestens einer Spuleneinrichtung (110, 112; 410, 112;, 510; 610; L1, L2), mittels welcher mindestens ein elektromagnetisches Wechselfeld erzeugbar ist;
wobei mittels Beaufschlagen des eingeleiteten ersten Gases (G1) in der ersten Reaktionskammer (101; 401; 501; 601) mit dem erzeugten mindestens einen elektromagnetischen Wechselfeld mindestens eine erste reaktive Spezies (R1) erzeugbar ist, und wobei mittels Beaufschlagen des eingeleiteten zweiten Gases (G2) in der zweiten Reaktionskammer (102; 402; 502; 602; 702) mit dem erzeugten mindestens einen elektromagnetischen Wechselfeld mindestens eine zweite reaktive Spezies (R2) erzeugbar ist;
einer Trenneinrichtung (120; 420; 620; 720), mittels welcher ein direkter Gasaustausch zwischen der ersten Reaktionskammer (101; 401; 501; 601) und der zweiten Reaktionskammer (102; 402; 502; 602) unterbunden oder unterdrückt ist;
einer Ätzkammer (150) zur Aufnahme des anisotrop zu ätzenden Substrats (152); und
einer Vermengungseinrichtung (130; 130, 132; 232, 243; 332; 432, 434), welche derart angeordnet und ausgebildet ist, dass die erzeugte mindestens eine erste reaktive Spezies (R1) und die erzeugte mindestens eine zweite reaktive Spezies (R2) sich bei einer Bewegung aus den beiden Reaktionskammern (101, 102; 401, 402; 501, 502; 601, 602) in Richtung der Ätzkammer (150) in der Vermengungseinrichtung (130; 130, 132; 232, 243; 332; 432, 434) miteinander vermengen und miteinander vermengt in die Ätzkammer (150) zum anisotropen Ätzen des Substrats (152) eintreten;
**dadurch gekennzeichnet, dass**
die Vermengungseinrichtung (130; 130, 132; 130, 232, 234; 130, 332; 130, 432, 434) mindestens eine erste Umleitungseinrichtung (132; 232; 332; 432) aufweist, mittels welcher, zum Umleiten mindestens eines Teils der erzeugten mindestens einen ersten reaktiven Spezies (R1), ein direkter Weg der erzeugten mindestens einen ersten reaktiven Spezies (R1) aus der ersten Reaktionskammer (101; 401; 501; 601; 701) zu dem Substrat (152) teilweise oder vollständig versperrt ist; und
wobei die erste Umleitungseinrichtung (132; 232; 332; 432) derart angeordnet ist, dass Gasströme der ersten reaktiven Spezies (R1) und der zweiten reaktiven Spezies (R2) ineinander gerichtet werden.

2. Vorrichtung nach Anspruch 1, wobei die Vermengungseinrichtung (130; 130, 132; 232, 243; 332; 432, 434) eine sich in Richtung der Ätzkammer (150) trichterförmig verjüngende Führungseinrichtung (130) zum Führen der miteinander vermengten mindestens einen ersten reaktiven Spezies (R1) und mindestens einen zweiten reaktiven Spezies (R2) auf das Substrat (152) aufweist.

3. Vorrichtung nach einem der vorangehenden Ansprüche 1 oder 2, wobei die Vermengungseinrichtung als eine Diffusionsstrecke ausgebildet ist.

4. Vorrichtung nach einem der vorangehenden Ansprüche 1 bis 3,
wobei zumindest ein erster Teilbereich (H4) der ersten Reaktionskammer (101; 401; 501; 601; 701) vollständig von zumindest einem zweiten Teilbereich (H2) der zweiten Reaktionskammer (102; 402; 502; 602; 702) umschlossen ist.

5. Vorrichtung nach einem der vorangehenden Ansprüche 1 bis 4,
wobei die Spuleneinrichtung (110, 112; 410, 112; L1, L2) eine erste induktive Spule (110; 410; L1) aufweist, welche zum Beaufschlagen der ersten Reaktionskammer (101; 401; 501; 601) mit einem ersten elektromagnetischen Wechselfeld ausgebildet ist; und wobei die Spuleneinrichtung (110, 112; 410, 112; L1, L2) weiterhin eine zweite induktive Spule (112; L2) aufweist, welche zum Beaufschlagen der zweiten Reaktionskammer (102; 402; 502; 602) mit einem zweiten elektromagnetischen Wechselfeld ausgebildet ist.

6. Vorrichtung nach einem der vorangehenden Ansprüche 1 bis 5, wobei die erste Reaktionskammer (101; 401; 501; 601) eine erste Einleitung (107) zum Einleiten des ersten Gases (G1) in die erste Reaktionskammer (101; 401; 501; 601) aufweist; wobei die erste Einleitung (107) über eine erste Ventileinrichtung mit einem ersten Gastank (105) sowie mit einem zweiten Gastank (106) verbunden ist; wobei die erste Ventileinrichtung steuerbar ist, entweder eine in dem ersten Gastank (105) bereitgestellte erste Gasspezies oder eine in dem zweiten Gastank (106) bereitgestellte zweite Gasspezies als das erste Gas (G1) in die erste Reaktionskammer (101; 401; 501; 601) einzuleiten;
und/oder
wobei die zweite Reaktionskammer (102; 402; 502; 602) eine zweite Einleitung (108) zum Einleiten des zweiten Gases (G2) in die zweite Reaktionskammer (102; 402; 502; 602) aufweist; wobei die zweite Einleitung (108) über eine zweite Ventileinrichtung mit dem ersten Gastank (105) sowie mit dem zweiten Gastank (106) verbunden ist; wobei die zweite Ventileinrichtung steuerbar ist, entweder die in dem ersten Gastank (105) bereitgestellte erste Gasspezies oder die in dem zweiten Gastank (106) bereitgestellte zweite Gasspezies als das zweite Gas (G2) in die zweite Reaktionskammer (102; 402; 502; 602) einzuleiten.

7. Vorrichtung nach einem der vorangehenden Ansprüche 1 bis 6, mit einer Temperierungseinrichtung (157), mittels welcher das Substrat (152) auf eine vorgegebene Betriebstemperatur zwischen zwanzig Grad Celsius und neunzig Grad Celsius, jeweils einschließlich, bringbar und auf der vorgegebenen Betriebstemperatur haltbar ist.

8. Vorrichtung nach einem der vorangehenden Ansprüche 1 bis 7,
wobei das erste Gas (G1) ein Passiviergas oder ein Ätzgas ist;
wobei das zweite Gas (G2) ein Ätzgas ist, wenn das erste Gas (G1) ein Passiviergas ist;
und wobei das zweite Gas (G2) ein Passiviergas ist, wenn das erste Gas (G1) ein Ätzgas ist;
wobei das Passiviergas ein Fluorkohlenwasserstoff, ein perfluoriertes Alken vorzugsweise Hexafluorpropen, ein perfluoriertes Alkin oder ein zyklisches perfluoriertes Alkan vorzugsweise Octafluorcyclobutan ist;
und
wobei das Ätzgas ein fluorlieferndes Gas vorzugsweise Schwefelhexafluorid oder Stickstofftrifluorid ist.

9. Verfahren zum Betreiben einer Vorrichtung nach einem der vorangehenden Ansprüche 1 bis 8 mit den Schritten:
Einleiten (S01) des ersten Gases (G1) in die erste Reaktionskammer (101; 401; 501; 601);
Einleiten (S02) des zweiten Gases (G2) in die zweite Reaktionskammer (102; 402; 502; 602) gleichzeitig mit dem Einleiten des ersten Gases (G1) in die erste Reaktionskammer (101; 401; 501; 601); und
Erzeugen (S03) des mindestens einen elektromagnetischen Wechselfelds zum Erzeugen der mindestens einen reaktiven Spezies (R1) aus dem ersten Gas (G1) und zum Erzeugen der mindestens einen zweiten reaktiven Spezies (R2) aus dem zweiten Gas (G2).

10. Verfahren nach Anspruch 9,
wobei als das erste Gas (G1) ein Passiviergas oder ein Ätzgas eingeleitet wird; wobei als das zweite Gas (G2) ein Ätzgas eingeleitet wird, wenn als das erste Gas (G1) ein Passiviergas eingeleitet wird und wobei als das zweite Gas (G2) ein Passiviergas eingeleitet wird, wenn als das erste Gas (G1) ein Ätzgas eingeleitet wird;
wobei das Passiviergas ein Fluorkohlenwasserstoff, ein perfluoriertes Alken, vorzugsweise Hexafluorpropen, ein perfluoriertes Alkin oder ein zyklisches perfluoriertes Alkan, vorzugsweise Octafluorcyclobutan ist; und
wobei das Ätzgas ein fluorlieferndes Gas, vorzugsweise Schwefelhexafluorid oder Stickstofftrifluorid ist.

11. Verfahren nach einem der vorangehenden Ansprüche 9 oder 10,
wobei mindestens einmal mit einer vorbestimmten Umschaltfrequenz zwischen einem ersten Betriebsmodus und einem zweiten Betriebsmodus, oder zwischen einem zweiten Betriebsmodus und einem ersten Betriebsmodus, umgeschaltet wird; wobei in dem ersten Betriebsmodus als das erste Gas (G1) ein Ätzgas und als das zweite Gas (G2) ein Passiviergas eingeleitet wird; und wobei in dem zweiten Betriebsmodus als das erste Gas (G1) ein Passiviergas und als das zweite Gas (G2) ein Ätzgas eingeleitet wird.

## Claims

1. Device for anisotropically etching a substrate, comprising
a first reaction chamber (101; 401; 501; 601), into which a first gas (G1) can be introduced;
a second reaction chamber (102; 402; 502; 602), into which a second gas (G2) can be introduced;
at least one coil unit (110, 112; 410, 112; 510; 610; L1, L2), by means of which at least one electromagnetic alternating field can be generated;
wherein at least one first reactive species (R1) can be generated by means of applying the generated at least one electromagnetic alternating field to the introduced first gas (G1) in the first reaction chamber (101; 401; 501; 601), and wherein at least one second reactive species (R2) can be generated by means of applying the generated at least one electromagnetic alternating field to the introduced second gas (G2) in the second reaction chamber (102; 402; 502; 602; 702);
a separating unit (120; 420; 620; 720), by means of which a direct gas exchange between the first reaction chamber (101; 401; 501; 601) and the second reaction chamber (102; 402; 502; 602) can be prevented or suppressed;
an etching chamber (150) for accommodating the substrate (152) to be anisotropically etched; and
a mixing unit (130; 130, 132; 232, 243; 332; 432, 434), which is arranged and designed such that the generated at least one first reactive species (R1) and the generated at least one second reactive species (R2) mix with one another during a movement from the two reaction chambers (101, 102; 401, 402; 501, 502; 601, 602) in the direction of the etching chamber (150) in the mixing unit (130; 130, 132; 232, 243; 332; 432, 434) and enter the etching chamber (150) for anisotropically etching the substrate (152) while mixed with one another;
**characterized in that**
the mixing unit (130; 130, 132; 130, 232, 234; 130, 332; 130, 432, 434) has at least one redirection unit (132; 232; 332; 432), by means of which, to redirect at least a part of the generated at least one first reactive species (R1), a direct path of the generated at least one first reactive species (R1) from the first reaction chamber (101; 401; 501; 601; 701) to the substrate (152) is partially or completely blocked; and
wherein the first redirection unit (132; 232; 332; 432) is arranged such that gas streams of the first reactive species (R1) and the second reactive species (R2) are oriented one into another.

2. Device according to Claim 1, wherein the mixing unit (130; 130, 132; 232, 243; 332; 432, 434) has a guide unit (130), which tapers in a funnel shape in the direction of the etching chamber (150), for guiding the at least one first reactive species (R1) and at least one second reactive species (R2), which are mixed with one another, to the substrate (152).

3. Device according to one of the preceding Claims 1 or 2, wherein the mixing unit is designed as a diffusion section.

4. Device according to one of the preceding Claims 1 to 3, wherein at least one first subregion (H4) of the first reaction chamber (101; 401; 501; 601; 701) is completely enclosed by at least one second subregion (H2) of the second reaction chamber (102; 402; 502; 602; 702).

5. Device according to one of the preceding Claims 1 to 4, wherein the coil unit (110, 112; 410, 112; L1, L2) has a first inductive coil (110; 410; L1), which is designed to apply a first electromagnetic alternating field to the first reaction chamber (101; 401; 501; 601); and wherein the coil unit (110, 112; 410, 112; L1, L2) furthermore has a second inductive coil (112; L2), which is designed to apply a second electromagnetic alternating field to the second reaction chamber (102; 402; 502; 602).

6. Device according to one of the preceding Claims 1 to 5, wherein the first reaction chamber (101; 401; 501; 601) has a first inlet line (107) for introducing the first gas (G1) into the first reaction chamber (101; 401; 501; 601); wherein the first inlet line (107) is connected via a first valve unit to a first gas tank (105) and to a second gas tank (106); wherein the first valve unit can be controlled to introduce either a first gas species provided in the first gas tank (105) or a second gas species provided in the second gas tank (106) as the first gas (G1) into the first reaction chamber (101; 401; 501; 601);
and/or
wherein the second reaction chamber (102; 402; 502; 602) has a second inlet line (108) for introducing the second gas (G2) into the second reaction chamber (102; 402; 502; 602); wherein the second inlet line (108) is connected via a second valve unit to the first gas tank (105) and to the second gas tank (106); wherein the second valve unit can be controlled to introduce either the first gas species provided in the first gas tank (105) or the second gas species provided in the second gas tank (106) as the second gas (G2) into the second reaction chamber (102; 402; 502; 602).

7. Device according to one of the preceding Claims 1 to 6, comprising a temperature-control unit (157), by means of which the substrate (152) can be brought to a predefined operating temperature between 20°C and 90°C, each inclusive, and can be held at the predefined operating temperature.

8. Device according to one of the preceding Claims 1 to 7,
wherein the first gas (G1) is a passivation gas or an etching gas;
wherein the second gas (G2) is an etching gas if the first gas (G1) is a passivation gas;
and wherein the second gas (G2) is a passivation gas if the first gas (G1) is an etching gas;
wherein the passivation gas is a fluorinated hydrocarbon, a perfluorinated alkene, preferably hexafluoropropene, a perfluorinated alkyne, or a cyclic perfluorinated alkane, preferably octafluorocyclobutane; and
wherein the etching gas is a fluorine-supplying gas, preferably sulfur hexafluoride or nitrogen trifluoride.

9. Method for operating a device according to one of the preceding Claims 1 to 8, having the following steps:
introducing (S01) the first gas (G1) into the first reaction chamber (101; 401; 501; 601);
introducing (S02) the second gas (G2) into the second reaction chamber (102; 402; 502; 602) simultaneously with the introduction of the first gas (G1) into the first reaction chamber (101; 401; 501; 601); and
generating (S03) the at least one electromagnetic alternating field to generate the at least one first reactive species (R1) from the first gas (G1) and to generate the at least one second reactive species (R2) from the second gas (G2).

10. Method according to Claim 9,
wherein a passivation gas or an etching gas is introduced as the first gas (G1);
wherein an etching gas is introduced as the second gas (G2) if a passivation gas is introduced as the first gas (G1), and wherein a passivation gas is introduced as the second gas (G2) if an etching gas is introduced as the first gas (G1);
wherein the passivation gas is a fluorinated hydrocarbon, a perfluorinated alkene, preferably hexafluoropropene, a perfluorinated alkyne, or a cyclic perfluorinated alkane, preferably octafluorocyclobutane; and
wherein the etching gas is a fluorine-supplying gas, preferably sulfur hexafluoride or nitrogen trifluoride.

11. Method according to one of the preceding Claims 9 or 10,
wherein it switches over at least once at a predetermined switching frequency between a first operating mode and a second operating mode, or between a second operating mode and a first operating mode; wherein an etching gas is introduced as the first gas (G1) and a passivation gas is introduced as the second gas (G2) in the first operating mode; and wherein a passivation gas is introduced as the first gas (G1) and an etching gas is introduced as the second gas (G2) in the second operating mode.

## Revendications

1. Dispositif pour la gravure anisotrope d'un substrat, comprenant :
une première chambre de réaction (101 ; 401 ; 501 ; 601), dans laquelle un premier gaz (G1) peut être introduit ;
une deuxième chambre de réaction (102 ; 402 ; 502 ; 602), dans laquelle un deuxième gaz (G2) peut être introduit ;
au moins un appareil à bobines (110, 112 ; 410, 112 ; 510 ; 610 ; L1, L2), au moyen duquel au moins un champ électromagnétique alternatif peut être généré ;
au moins une première espèce réactive (R1) pouvant être générée par sollicitation du premier gaz introduit (G1) dans la première chambre de réaction (101 ; 401 ; 501 ; 601) avec l'au moins un champ électromagnétique alternatif généré, et au moins une deuxième espèce réactive (R2) pouvant être générée par sollicitation du deuxième gaz introduit (G2) dans la deuxième chambre de réaction (102 ; 402 ; 502 ; 602 ; 702) avec l'au moins un champ électromagnétique alternatif généré ;
un appareil de séparation (120 ; 420 ; 620 ; 720), au moyen duquel un échange direct de gaz entre la première chambre de réaction (101; 401; 501; 601) et la deuxième chambre de réaction (102 ; 402 ; 502 ; 602) est empêché ou inhibé ;
une chambre de gravure (150) pour la réception du substrat à graver de manière anisotrope (152) ; et
un appareil de mélange (130 ; 130, 132 ; 232, 243 ; 332 ; 432, 434), qui est agencé et configuré de telle sorte que l'au moins une première espèce réactive (R1) générée et l'au moins une deuxième espèce réactive (R2) générée se mélangent l'une avec l'autre dans l'appareil de mélange (130 ; 130, 132 ; 232, 243 ; 332 ; 432, 434) lors d'un déplacement à partir des deux chambres de réaction (101, 102 ; 401, 402 ; 501, 502 ; 601, 602) en direction de la chambre de gravure (150) et pénètrent mélangées l'une avec l'autre dans la chambre de gravure (150) pour la gravure anisotrope du substrat (152) ;
**caractérisé en ce que**
l'appareil de mélange (130 ; 130, 132 ; 130, 232, 234 ; 130, 332 ; 130, 432, 434) comprend au moins un premier appareil de déviation (132 ; 232 ; 332 ; 432), au moyen duquel, pour la déviation d'au moins une partie de l'au moins une première espèce réactive (R1) générée, un chemin direct de l'au moins une première espèce réactive (R1) générée à partir de la première chambre de réaction (101; 401; 501; 601; 701) vers le substrat (152) est partiellement ou complètement bloqué ; et
dans lequel le premier appareil de déviation (132 ; 232 ; 332 ; 432) est agencé de telle sorte que des courants gazeux de la première espèce réactive (R1) et de la deuxième espèce réactive (R2) sont dirigés l'un dans l'autre.

2. Dispositif selon la revendication 1, dans lequel l'appareil de mélange (130 ; 130, 132 ; 232, 243 ; 332 ; 432, 434) comprend un appareil de guidage (130) se rétrécissant en forme d'entonnoir en direction de la chambre de gravure (150) pour le guidage de l'au moins une première espèce réactive (R1) et l'au moins une deuxième espèce réactive (R2) mélangées l'une avec l'autre sur le substrat (152).

3. Dispositif selon l'une quelconque des revendications 1 ou 2 précédentes, dans lequel l'appareil de mélange est configuré sous la forme d'une section de diffusion.

4. Dispositif selon l'une quelconque des revendications 1 à 3 précédentes,
dans lequel au moins une première zone partielle (H4) de la première chambre de réaction (101 ; 401 ; 501 ; 601 ; 701) est complètement entourée par au moins une deuxième zone partielle (H2) de la deuxième chambre de réaction (102 ; 402 ; 502 ; 602 ; 702).

5. Dispositif selon l'une quelconque des revendications 1 à 4 précédentes,
dans lequel l'appareil à bobines (110, 112 ; 410, 112 ; L1, L2) comprend une première bobine inductive (110 ; 410 ; L1), qui est configurée pour la sollicitation de la première chambre de réaction (101 ; 401 ; 501 ; 601) avec un premier champ électromagnétique alternatif ; et dans lequel l'appareil à bobines (110, 112 ; 410, 112 ; L1, L2) comprend en outre une deuxième bobine inductive (112 ; L2), qui est configurée pour la sollicitation de la deuxième chambre de réaction (102 ; 402 ; 502 ; 602) avec un deuxième champ électromagnétique alternatif.

6. Dispositif selon l'une quelconque des revendications 1 à 5 précédentes, dans lequel la première chambre de réaction (101 ; 401 ; 501 ; 601) comprend une première introduction (107) pour l'introduction du premier gaz (G1) dans la première chambre de réaction (101; 401; 501; 601) ; dans lequel la première introduction (107) est reliée à un premier réservoir de gaz (105) et à un deuxième réservoir de gaz (106) par l'intermédiaire d'un premier appareil à soupape ; dans lequel le premier appareil à soupape est apte à être commandé pour introduire soit une première espèce gazeuse mise à disposition dans le premier réservoir de gaz (105), soit une deuxième espèce gazeuse mise à disposition dans le deuxième réservoir de gaz (106) en tant que le premier gaz (G1) dans la première chambre de réaction (101 ; 401 ; 501 ; 601) ;
et/ou
dans lequel la deuxième chambre de réaction (102 ; 402 ; 502 ; 602) comprend une deuxième introduction (108) pour l'introduction du deuxième gaz (G2) dans la deuxième chambre de réaction (102 ; 402 ; 502 ; 602) ; dans lequel la deuxième introduction (108) est reliée au premier réservoir de gaz (105) et au deuxième réservoir de gaz (106) par l'intermédiaire d'un deuxième appareil à soupape ; dans lequel le deuxième appareil à soupape est apte à être commandé pour introduire soit une première espèce gazeuse mise à disposition dans le premier réservoir de gaz (105), soit une deuxième espèce gazeuse mise à disposition dans le deuxième réservoir de gaz (106) en tant que le deuxième gaz (G2) dans la deuxième chambre de réaction (102 ; 402 ; 502 ; 602).

7. Dispositif selon l'une quelconque des revendications 1 à 6 précédentes, comprenant un appareil de conditionnement en température (157), au moyen duquel le substrat (152) peut être amené à une température d'exploitation prédéterminée comprise entre vingt degrés Celsius et quatre-vingt-dix degrés Celsius, chacun inclus, et peut être maintenu à la température d'exploitation prédéterminée.

8. Dispositif selon l'une quelconque des revendications 1 à 7 précédentes,
dans lequel le premier gaz (G1) est un gaz de passivation ou un gaz de gravure ;
dans lequel le deuxième gaz (G2) est un gaz de gravure lorsque le premier gaz (G1) est un gaz de passivation ; et dans lequel le deuxième gaz (G2) est un gaz de passivation lorsque le premier gaz (G1) est un gaz de gravure ;
dans lequel le gaz de passivation est un hydrocarbure fluoré, un alcène perfluoré, de préférence l'hexafluoropropène, un alcyne perfluoré ou un alcane cyclique perfluoré, de préférence l'octafluorocyclobutane ;
et
dans lequel le gaz de gravure est un gaz délivrant du fluor, de préférence l'hexafluorure de soufre ou le trifluorure d'azote.

9. Procédé d'exploitation d'un dispositif selon l'une quelconque des revendications 1 à 8 précédentes, comprenant les étapes suivantes :
l'introduction (S01) du premier gaz (G1) dans la première chambre de réaction (101 ; 401 ; 501 ; 601) ;
l'introduction (S02) du deuxième gaz (G2) dans la deuxième chambre de réaction (102 ; 402 ; 502 ; 602) simultanément à l'introduction du premier gaz (G1) dans la première chambre de réaction (101 ; 401 ; 501 ; 601) ; et
la génération (S03) de l'au moins un champ électromagnétique alternatif pour la génération de l'au moins une espèce réactive (R1) à partir du premier gaz (G1) et pour la génération de l'au moins une deuxième espèce réactive (R2) à partir du deuxième gaz (G2).

10. Procédé selon la revendication 9,
dans lequel un gaz de passivation ou un gaz de gravure est introduit en tant que premier gaz (G1) ;
dans lequel un gaz de gravure est introduit en tant que deuxième gaz (G2) lorsqu'un gaz de passivation est introduit en tant que premier gaz (G1), et dans lequel un gaz de passivation est introduit en tant que deuxième gaz (G2) lorsqu'un gaz de gravure est introduit en tant que premier gaz (G1) ;
dans lequel le gaz de passivation est un hydrocarbure fluoré, un alcène perfluoré, de préférence l'hexafluoropropène, un alcyne perfluoré ou un alcane cyclique perfluoré, de préférence l'octafluorocyclobutane ; et
dans lequel le gaz de gravure est un gaz délivrant du fluor, de préférence l'hexafluorure de soufre ou le trifluorure d'azote.

11. Procédé selon l'une quelconque des revendications 9 ou 10 précédentes,
dans lequel on commute au moins une fois avec une fréquence de commutation prédéterminée entre un premier mode d'exploitation et un deuxième mode d'exploitation, ou entre un deuxième mode d'exploitation et un premier mode d'exploitation, ; dans lequel, dans le premier mode d'exploitation, un gaz de gravure est introduit en tant que premier gaz (G1) et un gaz de passivation est introduit en tant que deuxième gaz (G2) ; et dans lequel, dans le deuxième mode d'exploitation un gaz de passivation est introduit en tant que premier gaz (G1) et un gaz de gravure est introduit en tant que deuxième gaz (G2).
